# EUROPEAN PATENT APPLICATION

(11) **EP 4 646 077 A1**
(43) Date of publication of application: **05.11.2025**
(21) Application number: 23912326.8
(22) Date of filing: 28.12.2023
(51) Int. Cl.: H10K 30/50, H10K 30/40, H10K 30/86, H10K 85/50

(54) **PHOTOELECTRIC CONVERSION ELEMENT**

(30) Priority: 28.12.2022 JP 2022212548
(71) Applicant: Enecoat Technologies Co., Ltd., Kyoto 613-0031 (JP)
(72) Inventor: NAKAMICHI, Shinji, Kuse-gun, Kyoto 613-0031 (JP); TAKAHAMA, Tsuyoshi, Kuse-gun, Kyoto 613-0031 (JP); JAKAPAN, Chantana, Kuse-gun, Kyoto 613-0031 (JP); YAMAMOTO, Shuhei, Kuse-gun, Kyoto 613-0031 (JP)
(74) Representative: Louis Pöhlau Lohrentz
(86) International application number: PCT/JP2023/047299
(87) International publication number: WO 2024/143549

(57) **Abstract**

An object of the present invention is to provide a photoelectric conversion element having excellent photoelectric conversion characteristics and improved durability. A photoelectric conversion element 10 according to an aspect of the present invention has a structure in which a first electrode 12, a hole transport layer 13, a photoelectric conversion layer 14, an electron transport layer 15, and a second electrode 16 are laminated in this order. The photoelectric conversion layer 14 contains a perovskite compound. The hole transport layer 13 includes a p-type metal oxide semiconductor layer 13-1 and a hole transport material layer 13-2. The hole transport material layer 13-2 contains a compound represented by the following Chemical Formula (I).

Ar¹-(L¹-X¹)n ... (I)

In Chemical Formula (I), Ar¹ is a structure including an aromatic ring, atoms constituting the aromatic ring may contain a heteroatom, and Ar¹ may have a substituent other than - L¹-X¹. n is an integer of 1 or more, and when n is 2 or more, structures represented by -L¹-X¹ may be the same as or different from each other. L¹ is a divalent linking group bonding Ar¹ to X¹ or a single bond. X¹ is a group capable of forming a chemical bond or a hydrogen bond with the p-type metal oxide semiconductor.

## Description

### Technical Field

The present invention relates to a photoelectric conversion element.

### Background Art

In recent years, solar power generation has attracted attention as clean energy, and solar cells have been developed. As one of them, as a next-generation solar cell that can be manufactured at low cost, a solar cell using a perovskite material for a light absorbing layer has rapidly attracted attention. For example, Non Patent Literature 1 reports a solution-type solar cell using a perovskite material for a light absorbing layer. Non Patent Literature 2 also reports that a solid-type perovskite-type solar cell exhibits high efficiency.

As a basic structure of the perovskite-type solar cell, known are a forward structure in which an electron transport layer, a light absorption layer (perovskite layer), a hole transport layer (also referred to as a hole transport layer), and a back surface electrode are laminated in this order on an electrode, and a reverse structure in which a hole transport layer, a light absorption layer, an electron transport layer, and a back surface electrode are laminated in this order on an electrode. An electron transport layer having a porous shape may be provided between the electron transport layer and the perovskite layer. Among them, a hole transporting material of an organic semiconductor is generally used for the hole transport layer (for example, Non Patent Literatures 3 to 10).

### Citation List

### Non Patent Literature

Non Patent Literature 1: Journal of the American Chemical Society, 2009, 131, 6050-6051.
Non Patent Literature 2: Science, 2012, 388, 643-647.
Non Patent Literature 3: ACS Appl. Mater. Interfaces, 2017, 9, 24778-24787.
Non Patent Literature 4: Energy Environ. Sci., 2014, 7, 1454-1460.
Non Patent Literature 5: J. Mater. Chem. A, 2014, 2, 6305-6309.
Non Patent Literature 6: J. Mater. Chem. A, 2015, 3, 12139-12144.
Non Patent Literature 7: J. Mater. Chem. A, 2018, 6, 7950-7958.
Non Patent Literature 8: ACS Appl. Mater. Interfaces, 2015, 7, 11107-11116.
Non Patent Literature 9: Energy & Environmental Science 2014, 7, 2963-2967.
Non Patent Literature 10: Adv. Energy Mater., 2018, 8, 1801892.

### Summary of Invention

### Technical Problem

However, the conventional perovskite-type solar cell does not have sufficient photoelectric conversion efficiency. In order to improve the photoelectric conversion efficiency of the solar cell, it is particularly important to improve the characteristics of the hole transport layer. As a hole transporting material used for the hole transport layer, for example, a traxene compound (Non Patent Literature 3), a diketopyrrolopyrrole compound (Non Patent Literature 4), a thiophene compound (Non Patent Literatures 5 and 6), and dithienopyrrole (Non Patent Literature 7) have been reported so far. However, almost no compound capable of exhibiting photoelectric conversion efficiency that can be said to be useful as a perovskite-type solar cell has been reported. Therefore, Spiro-OMeTAD([2,2', 7,7'-Tetrakis (N,N-di-p-methoxyphenylamino)-9,9'-spirobifluorene]) developed as a hole transport material for a dye-sensitized solar cell has been proposed, but it is known that heat resistance is low (Non Patent Literature 8). In addition, a polymer material having a triphenylamine skeleton called PTAA (poly [bis(4-phenyl)(2,4,6-trimethylphenyl)amine]) is also known to have low light resistance. Furthermore, when these materials are used as a hole transport material for a p-buffer layer, it is necessary to improve conductivity by adding a LiTFSI salt (lithium bis(trifluoromethanesulfonyl)imide) as an additive, and this is considered to be one of causes of deterioration in the element (Non Patent Literature 9). In recent years, a carbazole-type hole transport material having phosphonic acid has been reported (Non Patent Literature 10). This compound reacts with an indium tin compound (ITO) used as a transparent electrode to form a monomolecular layer on the transparent electrode. The hole transport compound that forms this monomolecular layer is a very excellent compound that has been reported to have photoelectric conversion efficiency of more than 20%. However, when the coverage of the hole transport layer with respect to the electrode is not sufficient, the electrode and the photoelectric conversion layer come into contact with each other, the photoelectric conversion characteristics deteriorate, and the durability may be insufficient.

Therefore, an object of the present invention is to provide a photoelectric conversion element having excellent photoelectric conversion characteristics and improved durability.

### Solution to Problem

One aspect of the present invention is a photoelectric conversion element. The photoelectric conversion element including a first electrode, a hole transport layer, a photoelectric conversion layer, an electron transport layer, and a second electrode laminated in this order, wherein
the photoelectric conversion layer contains a perovskite compound, and
the hole transport layer includes a p-type metal oxide semiconductor layer laminated on a main surface of the first electrode, the main surface being located on a side of the photoelectric conversion layer, and a hole transport material layer laminated on a main surface of the p-type metal oxide semiconductor layer, the main surface being located on the side of the photoelectric conversion layer, the hole transport material layer containing a compound represented by the following Chemical Formula (I).

   Ar¹-(L¹-X¹)n ... (I)

In Chemical Formula (I), Ar¹ is a structure including an aromatic ring, atoms constituting the aromatic ring may contain a heteroatom, and Ar¹ may have a substituent other than -L¹-X¹. n is an integer of 1 or more, and when n is 2 or more, structures represented by -L¹-X¹ may be the same as or different from each other. L¹ is a divalent linking group bonding Ar¹ to X¹ or a single bond. X¹ is a group capable of forming a chemical bond or a hydrogen bond with a p-type metal oxide semiconductor.

In the photoelectric conversion element according to the above aspect, the hole transport material layer may contain a compound represented by the following Chemical Formula (II).

A¹-L²-X² ... (II)

A¹ is an atomic group including one or more substituents or structures selected from the group consisting of an alkoxy group, a hydroxy group, a carboxy group, a dihydroxyphosphoryl group, a dialkylphosphoryl group, a hydroxysulfonyl group, an amino group, a monoalkylamino group, a dialkylamino group, a monoarylamino group, a diarylamino group, a monoalkylaminocarbonyl group, a dialkylaminocarbonyl group, an alkylcarbonyloxy group, an alkoxycarbonyl group, an aminocarbonyl group, an aminocarbonylamino group, an alkylcarbonylamino group, an alkylsulfonylamino group, an aminosulfonyl group, and a nitrogen-containing heterocyclic group. L² is a divalent linking group that bonds A¹ to X² or a single bond. X² is a group capable of forming a chemical bond or a hydrogen bond with the first electrode.

The compound represented by Chemical Formula (I) may form a monomolecular layer.

A molar ratio of the compound represented by Chemical Formula (II) to the compound represented by Chemical Formula (I) is 1:100 to 1:1.

X¹ in Chemical Formula (I) may be selected from the group consisting of a dihydroxyphosphoryl group (-P = O(OH)₂), a carboxy group (-COOH), a sulfo group (-SO₃H), a boronic acid group (-B(OH)₂), a trihalogenated silyl group (-SiX₃, where X is a halo group), a trialkoxysilyl group (-Si(OR)₃, where R is an alkyl group), a trihydroxysilyl group, and a dialkylphosphoryl group.

X¹ in Chemical Formula (II) may be selected from the group consisting of a dihydroxyphosphoryl group (-P = O(OH)₂), a carboxy group (-COOH), a sulfo group (-SO₃H), a boronic acid group (-B(OH)₂), a trihalogenated silyl group (-SiX₃, where X is a halo group), a trialkoxysilyl group (-Si(OR)₃, where R is an alkyl group), a trihydroxysilyl group, and a dialkylphosphoryl group.

The perovskite compound may be an organic-inorganic perovskite compound.

The perovskite compound may contain at least one of tin and lead.

The organic-inorganic perovskite compound may contain at least one of tin and lead.

At least a part of the compound represented by Chemical Formula (I) may form an acid addition salt.

At least a part of the compound represented by Chemical Formula (II) may form an acid addition salt.

The p-type metal oxide semiconductor layer may be formed of particles of the p-type metal oxide semiconductor.

Each of the particles of the p-type metal oxide semiconductor may have a diameter of 1.0 to 30.0 nm.

### Advantageous Effects of Invention

According to the present invention, it is possible to provide a photoelectric conversion element having excellent photoelectric conversion characteristics and improved durability.

### Brief Description of Drawings

[Fig. 1] Fig. 1 is a cross-sectional view illustrating an example of a configuration of a photoelectric conversion element according to an embodiment.
[Fig. 2] Fig. 2 is a diagram illustrating a particle size distribution of a nickel oxide powder.

### Description of Embodiments

The present invention will be described in more detail with reference to examples. However, the present invention is not limited by the following description. It is noted that a description will be given below as to a case in which a photoelectric conversion element according to an embodiment is a solar cell.

### [Photoelectric Conversion Element]

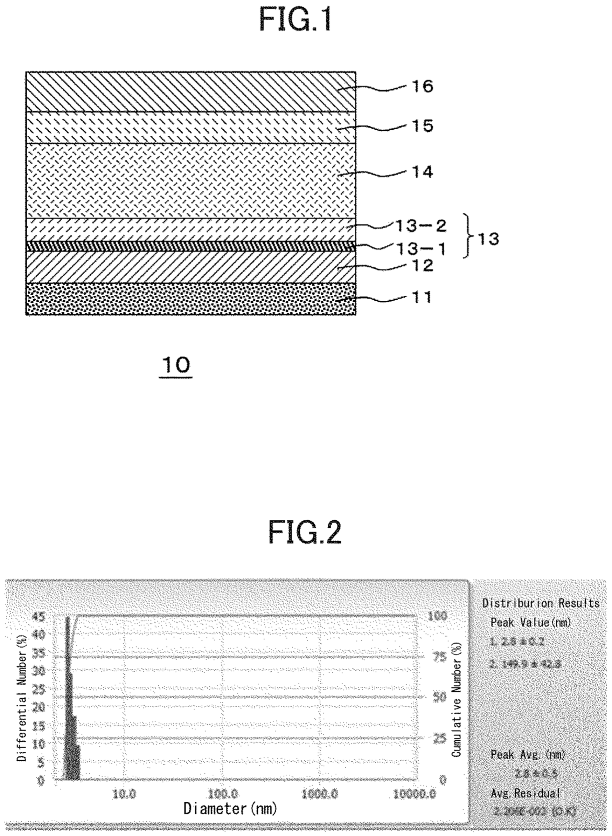

Fig. 1 is a cross-sectional view illustrating an example of a configuration of a photoelectric conversion element 10 according to an embodiment. It is noted that Fig. 1 is a diagram schematically illustrating the photoelectric conversion element with appropriate omission, exaggeration, or the like for convenience of description. As illustrated in Fig. 1, the photoelectric conversion element 10 has a laminated structure in which a first electrode 12, a hole transport layer 13, a photoelectric conversion layer 14, an electron transport layer 15, and a second electrode 16 are laminated in this order on a support (also referred to as a substrate, a base material, and the like) 11.

Hereinafter, each configuration of the photoelectric conversion element 10 will be described in detail.

### [Support]

The support 11 is not particularly limited, and for example, a substrate that can be used for a photoelectric conversion element such as a general solar cell may be appropriately used. Examples of the substrate include glass, a plastic plate, a plastic film, and an inorganic crystalline body. In addition, a substrate in which at least one film of a metal film, a semiconductor film, a conductive film, and an insulating film is formed on a part or the whole of the substrate surface can also be suitably used as the support 11. The size, thickness, and the like of the support 11 are not particularly limited, and for example, may be the same as or similar to a photoelectric conversion element such as a general solar cell.

### [First Electrode]

The first electrode 12 is, for example, a layer that supports the hole transport layer 13 and has a function of extracting a hole from the photoelectric conversion layer 14. In addition, the first electrode 12 is, for example, a layer serving as a cathode (positive electrode).

For example, the first electrode 12 may be formed directly on the support 11. The first electrode 12 may be, for example, a transparent electrode formed of a conductor. The transparent electrode is not particularly limited, and examples thereof include a tin-doped indium oxide (ITO) film, an impurity-doped indium oxide (In₂O₃) film, an impurity-doped zinc oxide (ZnO) film, a fluorine-doped tin dioxide (FTO) film, a laminated film formed by laminating two or more kinds thereof, gold, silver, copper, aluminum, tungsten, titanium, chromium, nickel, and cobalt. These films may be used alone or as a mixture of two or more kinds thereof, or may be a single layer or a laminate. In addition, these films may function as, for example, a diffusion prevention layer. The thickness of the first electrode 12 is not particularly limited, but for example, is preferably adjusted such that sheet resistance is 5 to 15 Ω/A (per unit area). A method of forming the first electrode 12 is not particularly limited, but can be obtained by, for example, a known film formation method according to a material to be formed. The shape of the first electrode 12 is also not particularly limited, and may be, for example, a film shape or a lattice shape such as a mesh shape. A method of forming the first electrode 12 on the support 11 is not particularly limited, but for example, a known method may be used, and for example, vacuum deposition such as vacuum film formation or sputtering is preferable. The first electrode 12 may be patterned. Examples of a patterning method include, but are not limited to, a method of immersing in a laser or an etching solution, a method of performing patterning using a mask during vacuum film formation, and the like, and any method may be used in the present invention. In addition, metal wiring or the like may be used in combination as the first electrode 12 for the purpose of lowering an electric resistance value. A material of the metal wiring (metal lead wire) is not particularly limited, and examples thereof include aluminum, copper, silver, gold, platinum, and nickel. The metal lead wire can be used in combination by forming the metal lead wire on the first substrate by, for example, vapor deposition, sputtering, pressure bonding, or the like, and providing a layer of ITO or FTO thereon, or providing the metal lead wire on ITO or FTO.

### [Hole Transport Layer]

As shown in Fig. 1, the hole transport layer 13 includes a p-type metal oxide semiconductor layer 13-1 and a hole transport material layer 13-2.

The p-type metal oxide semiconductor layer 13-1 is laminated on the main surface of the first electrode 12 on the photoelectric conversion layer 14 side.

A p-type metal oxide semiconductor used for the p-type metal oxide semiconductor layer 13-1 is preferably a semiconductor material formed of a metal oxide that transports a hole, and specific examples thereof include an oxide formed of an oxide such as nickel, copper, or aluminum alone or in a mixture. The p-type metal oxide semiconductor layer 13-1 may be a single layer or a multilayer, and in the case of a multilayer, the p-type metal oxide semiconductor layer may have a porous shape in which semiconductor fine particles having different particle sizes are applied in multiple layers. In the case of the porous shape, the particle size of the semiconductor fine particles is preferably 3 to 100 nm, and more preferably 5 to 70 nm. The film thickness of the p-type metal oxide semiconductor layer 13-1 is preferably 1 to 1000 nm, and more preferably 10 to 500 nm. A method of forming the p-type metal oxide semiconductor layer 13-1 is not particularly limited, and may be any of vacuum film formation such as sputtering or ion plating, and wet film formation such as sol-gel.

The p-type metal oxide semiconductor layer 13-1 may be formed of particles of a p-type metal oxide semiconductor. In this case, the diameter of the particles is, for example, 0.2 to 60.0 nm, preferably 1.0 to 30.0 nm, more preferably 1.0 to 10.0 nm, and still more preferably 2.0 to 3.5 nm.

The diameter of the particles of the p-type metal oxide semiconductor herein means an average particle size (particle size with an integrated value of 50%) measured by a dynamic scattering method using a zeta potential/particle size/molecular weight measurement system ELSZ-2000 manufactured by Otsuka Electronics Co., Ltd., in which the particles are sufficiently dispersed in deionized water at room temperature, and obtained dispersion liquid is caused to pass through a 0.45 µm PVDF filter.

The diameter of the particles of the p-type metal oxide semiconductor used for forming the p-type metal oxide semiconductor layer (formed using the particles of the p-type metal oxide semiconductor) may be obtained by the above-described measurement method. In addition, the particles contained in the p-type metal oxide semiconductor layer (formed using the particles of the p-type metal oxide semiconductor) in the completed photoelectric conversion element may be taken out and may be measured by the above-described measurement method to obtain the diameter.

It is noted that, when the p-type metal oxide semiconductor layer 13-1 is formed of p-type metal oxide semiconductor particles, at least a part of all the p-type metal oxide semiconductors in the p-type metal oxide semiconductor layer 13-1 may be formed of p-type metal oxide semiconductor particles, and for example, 30 to 100 mass% (preferably 70 to 100 mass%, more preferably 90 to 100 mass%, and still more preferably 98 to 100 mass%) of the total mass of the p-type metal oxide semiconductor in the p-type metal oxide semiconductor layer 13-1 is preferably formed of the p-type metal oxide semiconductor particles.

The surface of the p-type metal oxide semiconductor layer 13-1 may be covered with a very thin insulating layer as long as hole transportability is not impaired. Examples of the insulating layer include insulating metal oxides formed of oxides such as aluminum, magnesium, silicon, niobium, strontium, barium, titanium, zinc, and vanadium alone or in mixture. The thickness of the insulating metal oxide is preferably thin, preferably 1 to 20 nm, and more preferably 2 to 10 nm. The method of forming the insulating metal oxide is not particularly limited, and may be either vacuum film formation such as sputtering or ion plating or wet film formation such as sol-gel.

The hole transport material layer 13-2 is formed on the main surface of the p-type metal oxide semiconductor layer 13-1 on the photoelectric conversion layer 14 side. The hole transport material layer 13-2 contains a compound represented by the following Chemical Formula (I). In other words, the hole transport material layer 13-2 covers the main surface of the p-type metal oxide semiconductor layer 13-1 on the photoelectric conversion layer 14 side. A preferred embodiment of the hole transport material layer 13-2 includes a compound represented by the following Chemical Formula (I), which forms a chemical bond or a hydrogen bond with the p-type metal oxide semiconductor constituting the p-type metal oxide semiconductor layer 13-1.

Ar¹-(L¹-X¹)n ... (I)

In Chemical Formula (I), Ar¹ is a structure including an aromatic ring, atoms constituting the aromatic ring may contain a heteroatom, and Ar¹ may have a substituent other than -L¹-X¹. n is an integer of 1 or more, and when n is 2 or more, structures represented by -L¹-X¹ may be the same as or different from each other. The upper limit of n is preferably 3 or 4. L¹ is a divalent linking group bonding Ar¹ to X¹ or a single bond. X¹ is a group capable of forming a chemical bond or a hydrogen bond with the p-type metal oxide semiconductor.

### (Compound Represented by Chemical Formula (I))

In Chemical Formula (I), X¹ is each independently selected from the group consisting of a dihydroxyphosphoryl group (-P = O(OH)₂), a carboxy group (-COOH), a sulfo group (-SO₃H), a boronic acid group (-B(OH)₂), a trihalogenated silyl group (-SiX₃ with the proviso that X is a halo group), a trialkoxysilyl group (-Si(OR)₃, where R is an alkyl group), a trihydroxysilyl group, and a dialkylphosphoryl group.

In Chemical Formula (I), Ar¹ is specifically preferably, for example, an aromatic ring group, a group in which a plurality of aromatic ring groups is bonded to each other by a single bond, or a group in which one or more aromatic ring groups are condensed in a ring having no aromaticity.

The aromatic ring group may be a single ring or multiple rings (for example, 2 to 14 rings), and may have 1 or more (for example, 1 to 10) heteroatoms (nitrogen atom, sulfur atom, and/or oxygen atom, etc). The number of ring member atoms of the aromatic ring group is preferably 5 to 40.

Examples of the aromatic ring group include a benzene ring group, a pyrrole ring group, a furan ring group, a thiophene ring group, and a group obtained by condensation of two or more (for example, 2 to 14) selected from these groups.

Examples of the aromatic ring group constituting the group formed by bonding the plurality of aromatic ring groups to each other by a single bond include the above-described aromatic ring group. The number of aromatic ring groups bonded to each other by a single bond is preferably, for example, 2 to 6.

Specific examples of the group in which a plurality of aromatic ring groups is bonded to each other by a single bond include a biphenyl ring group and a bithiophene ring group.

An example of an aromatic ring group constituting a group obtained by ring-fusing the one or more aromatic ring groups to a ring having no aromaticity include the aromatic ring group described above.

Among the groups formed by ring-fusing the one or more aromatic ring groups to the ring having no aromaticity, the number of aromatic ring groups fused to the ring having no aromaticity is preferably, for example, 2 to 6.

Only one or a plurality of rings having no aromaticity may be present in a group obtained by ring-fusing the one or more aromatic ring groups to the ring having no aromaticity.

Among the groups obtained by ring-fusing the one or more aromatic ring groups to the ring having no aromaticity, the rings having no aromaticity may each independently be a single ring or multiple rings (for example, 2 to 14 rings), and may have one or more (for example, 1 to 10) heteroatoms (nitrogen atom, sulfur atom, and/or oxygen atom, and the like).

Specific examples of the group in which one or more aromatic ring groups are condensed with the ring having no aromaticity include a phenothiazine ring group and a 1, 2:3, 4:5, 6:7, 8-tetrakis [imino(1,2-phenylene)] cyclooctatetraene ring group.

In Chemical Formula (I), examples of L¹ which is a divalent linking group include a *1-alkylene group-*2 and a *1-alkylene group-aromatic ring group-*2. Here, *1 represents a bonding position on the Ar¹ side, and *2 represents a bonding position on the X¹ side. The alkylene group may be linear or branched, and the number of carbon atoms is preferably 1 to 6. Examples of the aromatic ring group include the same aromatic ring groups as those described above as the aromatic ring group which can be Ar¹. The alkylene group and the aromatic ring group may further have a substituent.

Specific examples of the compound represented by Chemical Formula (I) include compounds (A-01) to (A-21) having the following structures.

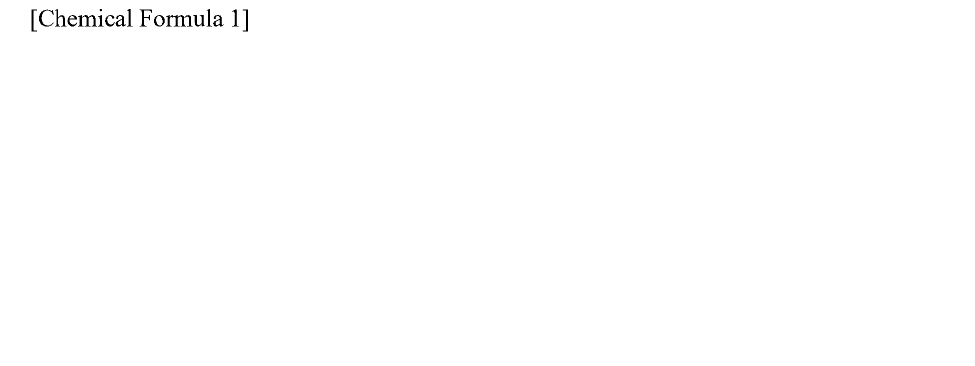

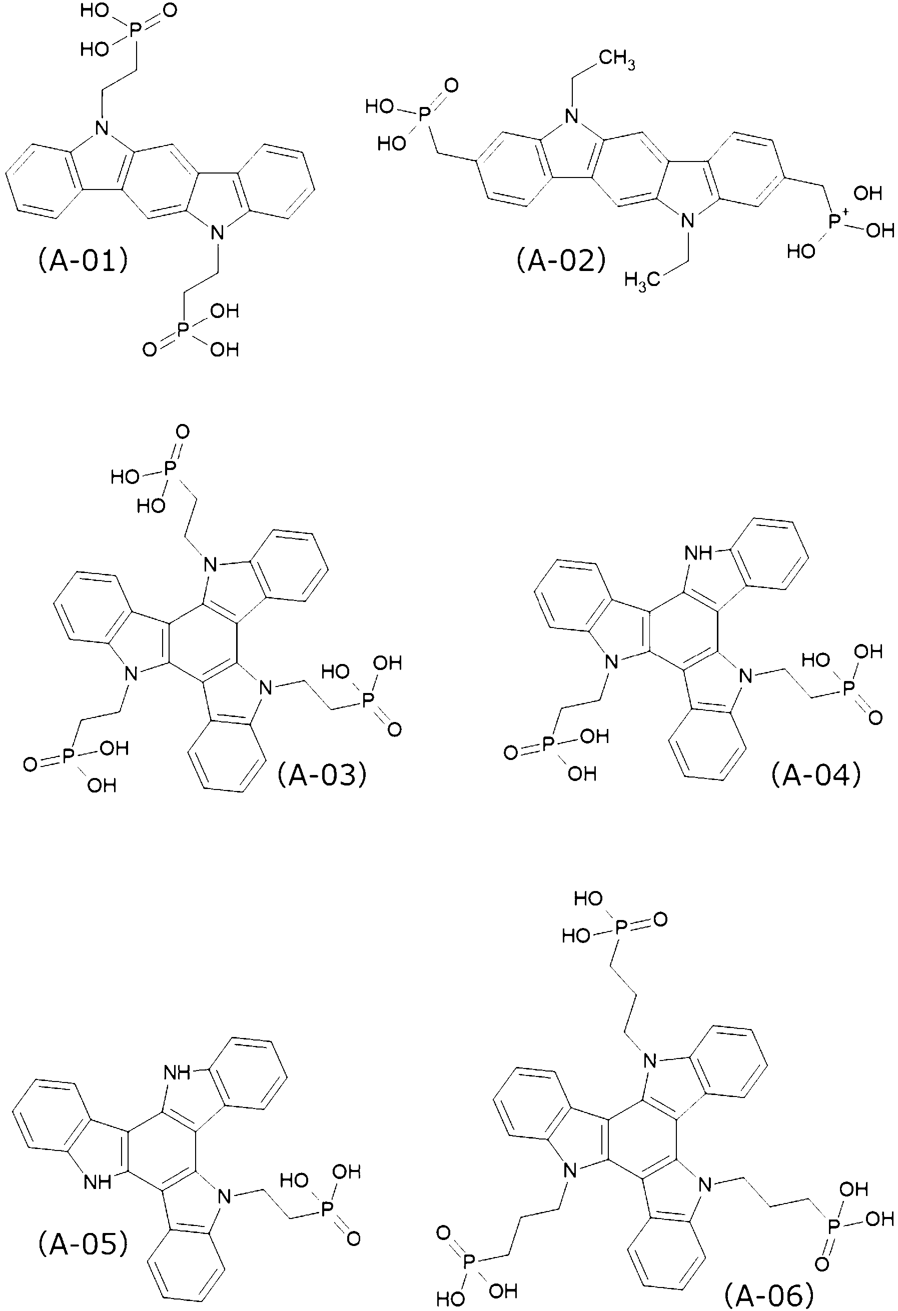

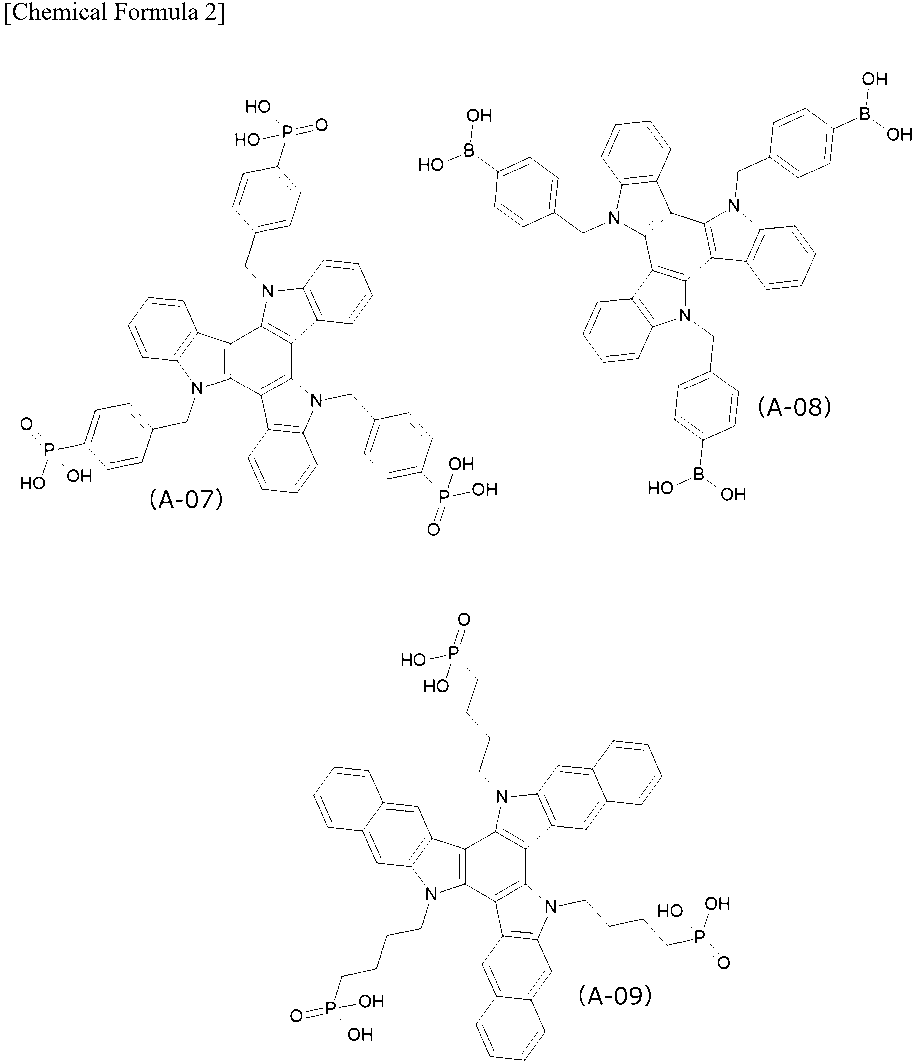

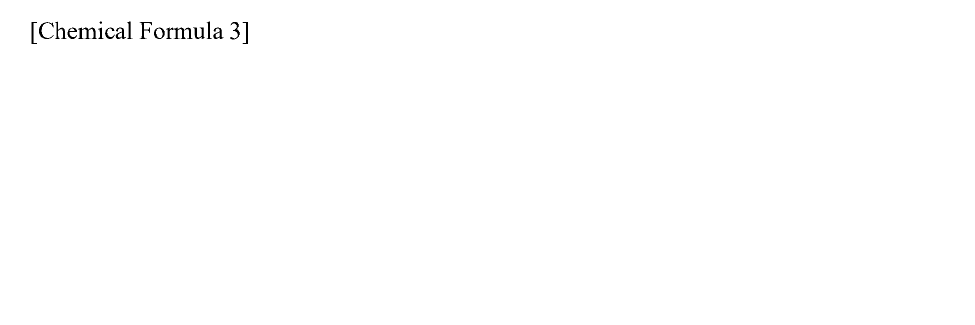

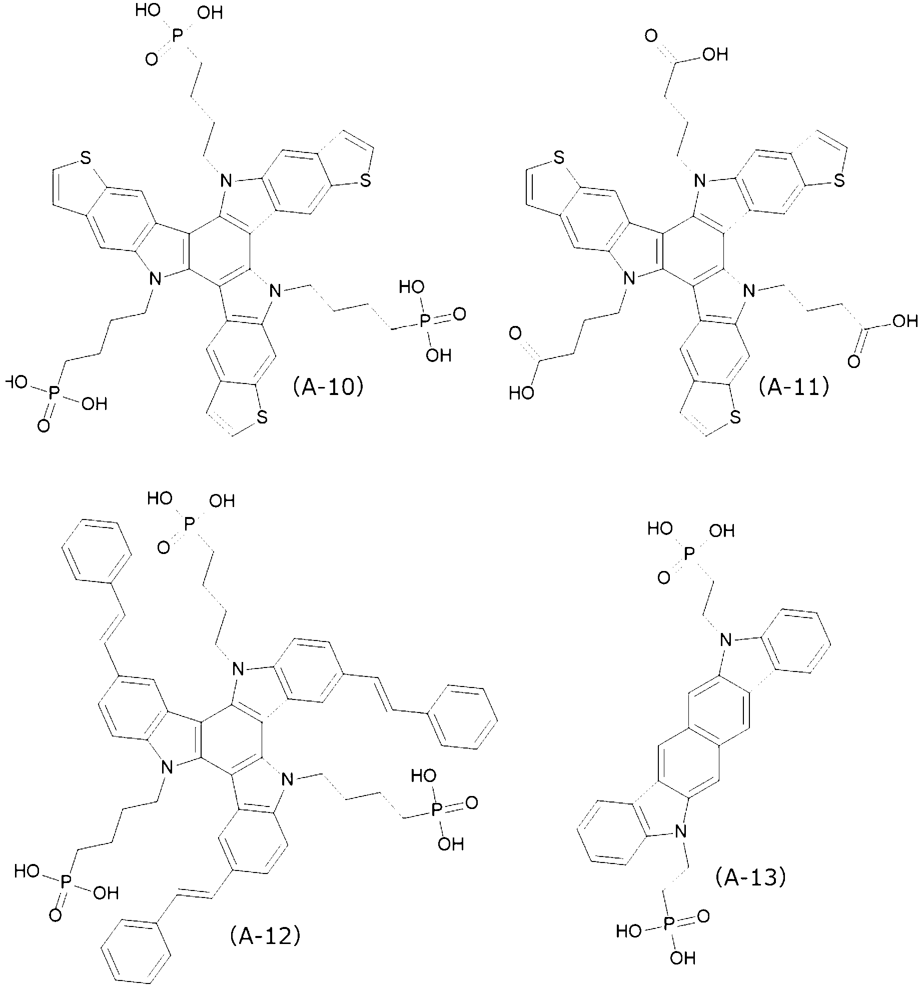

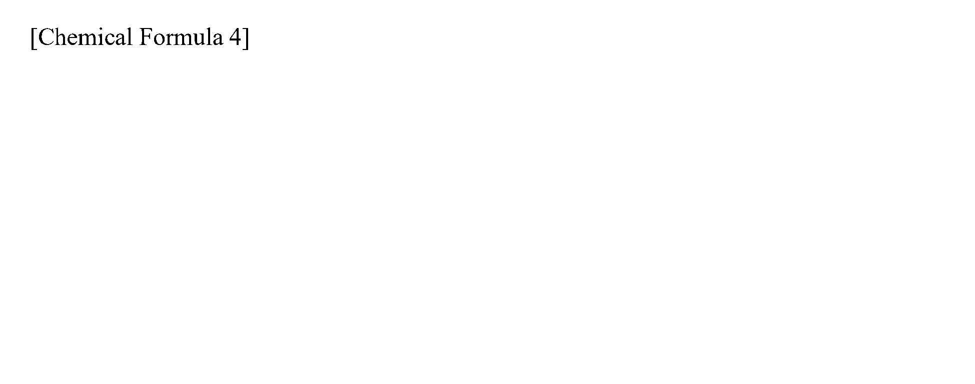

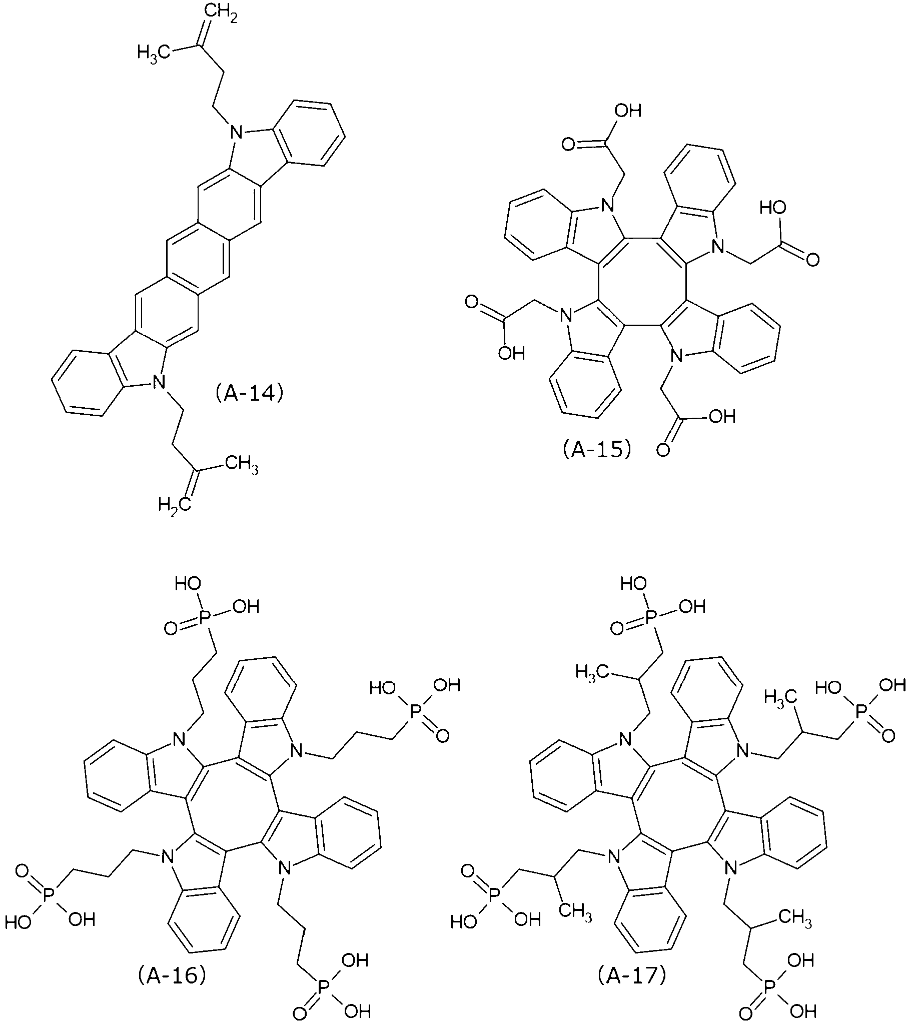

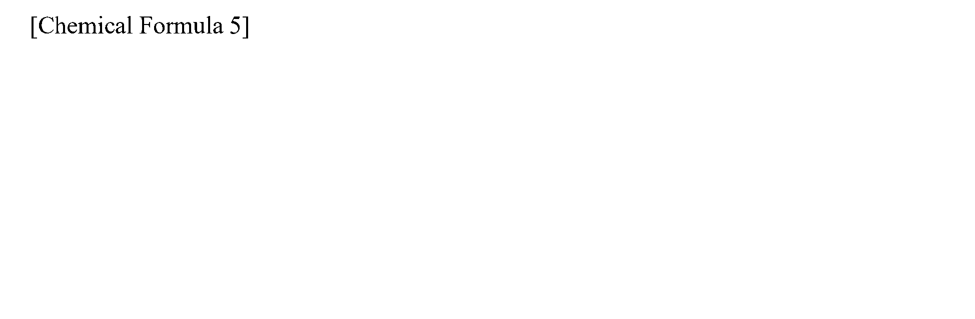

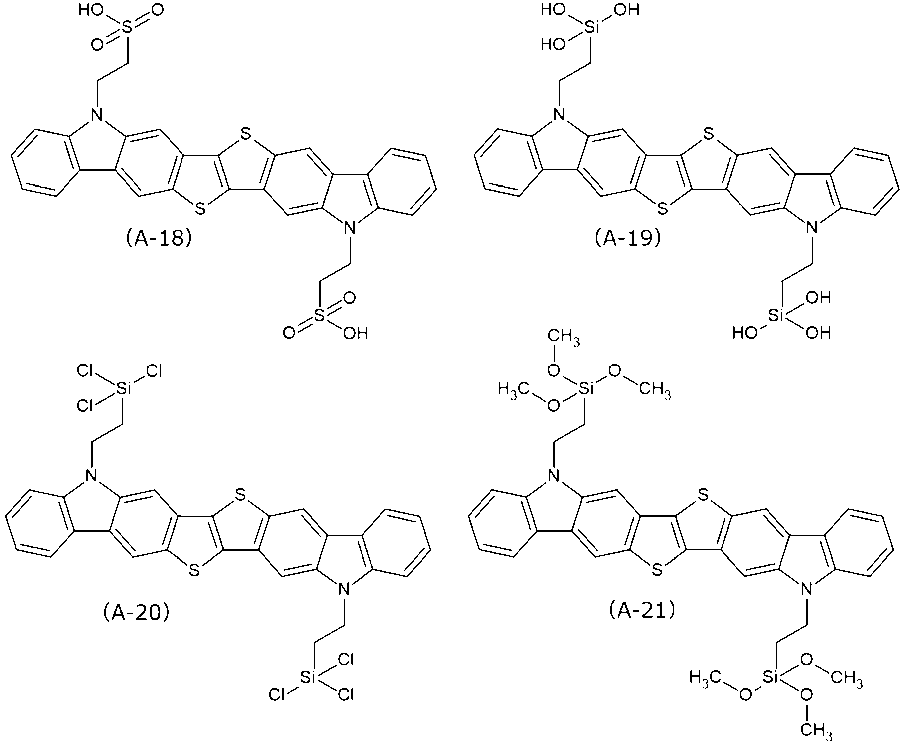

The compound represented by Chemical Formula (I) may be formed as, for example, a monomolecular layer on the p-type metal oxide semiconductor layer 13-1.

### (Compound Represented by Chemical Formula (II))

The hole transport material layer 13-2 may contain a compound represented by the following chemical formula (II) in addition to the compound represented by the above-mentioned Chemical Formula (I). In other words, a compound represented by the following Chemical Formula (II) is used in combination as a co-adsorbent. In a preferred embodiment of the hole transport material layer 13-2, the compound represented by Chemical Formula (II) forms a chemical bond or a hydrogen bond with the p-type metal oxide semiconductor constituting the p-type metal oxide semiconductor layer 13-1.

A¹-L²-X² ... (II)

A¹ is an atomic group including one or more substituents or structures selected from the group consisting of an organic amino group such as a monoalkylamino group, a dialkylamino group, a monoarylamino group, a diarylamino group, an aminocarbonylamino group, an alkylcarbonylamino group or an alkylsulfonylamino group, an alkoxy group, a hydroxy group, a carboxy group, a dihydroxyphosphoryl group, a dialkylphosphoryl group, a hydroxysulfonyl group, an amino group, a monoalkylaminocarbonyl group, a dialkylaminocarbonyl group, an alkylcarbonyloxy group, an alkoxycarbonyl group, an aminocarbonyl group, an aminosulfonyl group, and a nitrogen-containing heterocyclic group (which may or may not have aromaticity, may be a single ring or a multiple ring, and the number of ring member atoms is preferably 5 to 15, the number of nitrogen atoms in the ring member atoms is preferably 1 to 5, and may have a heteroatom other than a nitrogen atom (preferably 1 to 3). For example, a pyridine ring group, a quinoline ring group, an aziridine ring group, an azetidine ring group, a pyrrolidine ring group, an imidazolidine ring group, an imidazolidine-2 one ring group, a 2,3-dihydro-1H-pyrrole ring group, a pyrrole ring group, a pyrazole ring group, an imidazole ring group, a 1H-1,2,3-triazole ring group, a 2H-1,2,3-triazole ring group, a thiazole ring group, a morpholine ring group, a piperidine ring group, a piperazine ring group, a pyrazine ring group, a hexamethyleneimine ring group, a 1H-azepine ring group, an indole ring group, a 2,3-trimethylene indoline ring group, and a quinoxaline ring group). A¹ may be the substituents listed above or the structure itself. It is noted that, when the substituent or structure listed above in A¹ has an alkyl group moiety (including a moiety which is an alkyl group in an alkoxy group), the alkyl groups may be each independently linear or branched, and the number of carbon atoms is preferably 1 to 8.

L² is a divalent linking group that bonds A¹ to X² or a single bond. X² is a group capable of forming a chemical bond or a hydrogen bond with the first electrode.

In the compound represented by Chemical Formula (II), since A¹ has a hydrophilic function, wettability to the perovskite solution applied and formed on the hole transport layer 13 is improved. Since the film thickness of the perovskite layer can be uniformly applied by improving the wettability with respect to the perovskite solution, it is considered that the effect of reducing a variation is exerted particularly at the time of large area application.

In Chemical Formula (II), when the atomic group represented by A¹ includes a monoarylamino group or a diarylamino group, examples of the aryl group moiety in these groups include the same groups as those described above as the aromatic ring group that can be Ar¹.

The atomic group represented by A¹ is an organic amino group such as a monoalkylamino group, a dialkylamino group, a monoarylamino group, a diarylamino group, an aminocarbonylamino group, an alkylcarbonylamino group, or an alkylsulfonylamino group, an alkoxy group, a dialkylphosphoryl group, an amino group, a monoalkylaminocarbonyl group, a dialkylaminocarbonyl group, an alkylcarbonyloxy group, an alkoxycarbonyl group, an aminocarbonyl group, an aminosulfonyl group, or a nitrogen-containing heterocyclic group, and may further have one or more (preferably 1 to 6) substituents. The substituent that these groups may further have may be the same group as the group that X² or -L²-X² in Chemical Formula (II) can form. In the compound represented by Chemical Formula (II), it is also preferable that there are two or more (for example, 2 to 6) groups that can be formed by -L²-X² in Chemical Formula (II) as a whole.

In Chemical Formula (II), X² is each independently selected from the group consisting of a dihydroxyphosphoryl group (-P = O(OH)₂), a carboxy group (-COOH), a sulfo group (-SO₃H), a boronic acid group (-B(OH)₂), a trihalogenated silyl group (-SiX₃ with the proviso that X is a halo group), or a trialkoxysilyl group (-Si(OR)₃, where R is an alkyl group), and a dialkylphosphoryl group of a trihydroxysilyl group.

In Chemical Formula (II), L² which is a divalent linking group may be, for example, an alkylene group (the carbon number may be linear or branched, and is preferably 1 to 8), a vinylene group, a vinylidene group, an acetylene group, an aromatic ring group (for example, an aromatic ring group described as an aromatic ring group capable of forming Ar¹ in Chemical Formula (I)), or a non-aromatic ring group (a monocyclic ring or a polycyclic ring, or may have a heteroatom. An example thereof includes a piperazine ring group), -O-, -S-, -NR^{N}-(R^{N} is a hydrogen atom or an alkyl group. The alkyl group may be linear or branched, and the number of carbon atoms is preferably 1 to 8), and a divalent linking group composed of a combination of two or more (for example, 2 to 6) thereof. The divalent linking group composed of a combination of two or more may be a combination of the same kind of groups (however, a combination in which alkylene groups are continuously bonded to each other is not included).

If possible, these divalent linking groups may further have one or more (for example, 1 to 6) substituents, and for example, may have the same groups as those described as one or more (for example, 1 to 6) A¹ or X² as substituents.

Specific examples of the compound represented by Chemical Formula (II) include 3-methoxypropionic acid, 3-hydroxypropionic acid, 2-hydroxypropionic acid, malonic acid, succinic acid, glutaric acid, adipic acid, sebacic acid, phthalic acid, terephthalic acid, maleic acid, fumaric acid, citraconic acid, mesaconic acid, methylene succinic acid, allyl malonic acid, isopropylidene succinic acid, acetylenedicarboxylic acid, dimethyl terephthalate, diethyl terephthalate, 4,4'-biphenyldicarboxylic acid, diethyl 4,4'-biphenyldicarboxylic acid, 4-methoxybenzoic acid, 3,4-dimethoxybenzoic acid, 4-(methylamino) benzoic acid, 4-(methylamino) benzenesulfonic acid, 4-(methylamino) butanoic acid, 3-(carboxymethylamino) propionic acid, 6-acetoxy-2-naphthoic acid, acetylsalicylic acid, 4-(methoxycarbonyl) cyclohexanecarboxylic acid, 4-(methoxycarbonyl) phenylboronic acid, 4-(N,N-diethylaminocarbonyl) phenylboronic acid, 3-(methylaminocarbonyl) acrylic acid, N-(aminocarbonyl) aspartic acid, 4-acetylaminobenzoic acid, 2-(acetylamino) acrylic acid, gallic acid, 4-pyridinecarboxylic acid, 6-quinolinecarboxylic acid, aspartic acid, 2,2-diethoxyethylphosphonic acid, methylenediphosphonic acid, 1,2-ethylenediphosphonic acid, tetraethyl 1,2-ethylenediphosphonic acid, 1,3-propylenediphosphonic acid, 3,4-dimethoxyphenylphosphonic acid, (4-hydroxybenzyl) phosphonic acid, 4-hydroxyphenylphosphonic acid, [3-(3-carboxypiperazine-1-yl) propyl] phosphonic acid, (pyridine-4-ylmethyl) phosphonic acid, (pyridine-3-ylmethyl) phosphonic acid, 4-phosphonobenzoic acid, 3-phosphonopropionic acid, 4-phosphonobutylic acid, diethyl (4-methoxybenzyl) phosphonate, p-carboxybenzenesulfonylamide, 2-(dimethylamino) ethanesulfonic acid, 1,2-ethanesulfonic acid, and the like.

Specific examples of L² include alkylene such as 1,1-ethylene, 1,2-ethylene, 1,3-propylene, and 2-ethyl-1,6-hexylene, and a part of the alkylene may be alkenylene having a carbon-carbon double bond or alkynylene having a triple bond. Examples of the heterocyclic ring include arylenes such as 1,2-phenylene, 1,4-phenylene, 1,5-naphthylene, and 4,4'-biphenylene, and divalent heterocyclic rings such as 2,5-thienylene, 5,5'-bithienylene, 2,5-thieno [3,2-b] thienylene, and 2,6-pyridylene.

In the compound represented by Chemical Formula (II) above, examples of the case in which a salt is formed from a nitrogen atom and an anion include an ammonium salt, an aziridinium salt, an azirinium salt, an azetidinium salt, a pyrrolidinium salt, a pyrrolidinium salt, a pyrrolidinium salt, a pyrazolinium salt, a pyrrolinium salt, an imidazolinium salt, a triazolinium salt, a tetrazolinium salt, a piperidinium salt, a piperazinium salt, a pyridinium salt, a pyrazinium salt, a morpholinium salt, a thiazolinium salt, an azepinium salt, an azepinium salt, an indolinium salt, a quinolinium salt, an isoquinolinium salt, a quinoxalinium salt, a phenanthrolinium salt, and a phenazinium salt. The acid that reacts with the compound represented by Chemical Formula (II) to form a salt may be any of an organic acid and an inorganic acid to be described later as an acid that forms an acid addition salt, and may be a mixture.

Specific examples of the compound represented by Chemical Formula (II) include compounds (B-01) to (B-52) having the following structures.

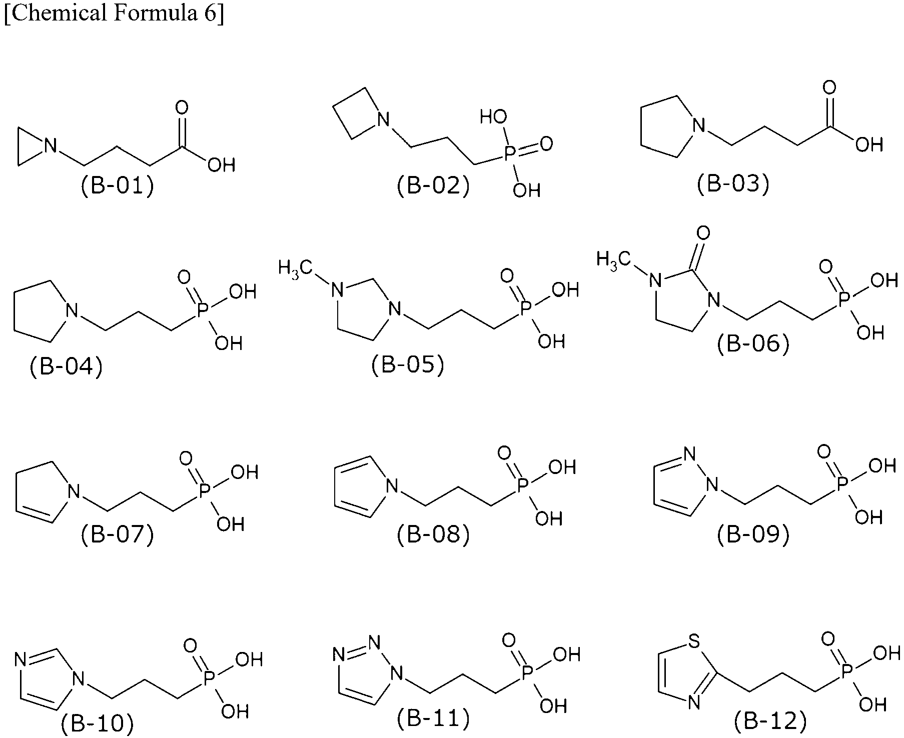

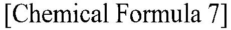

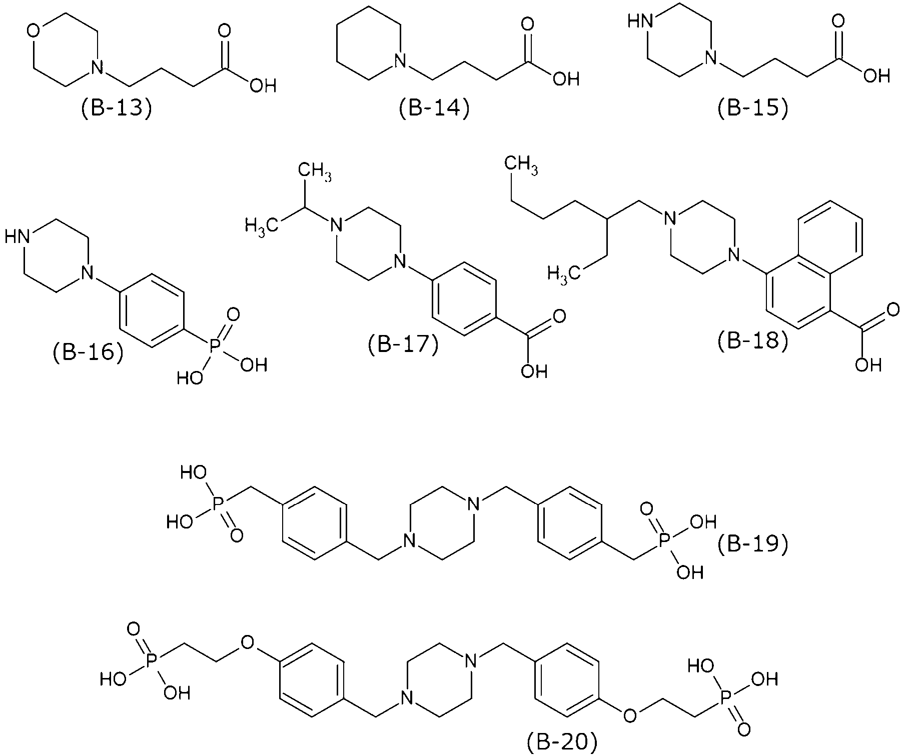

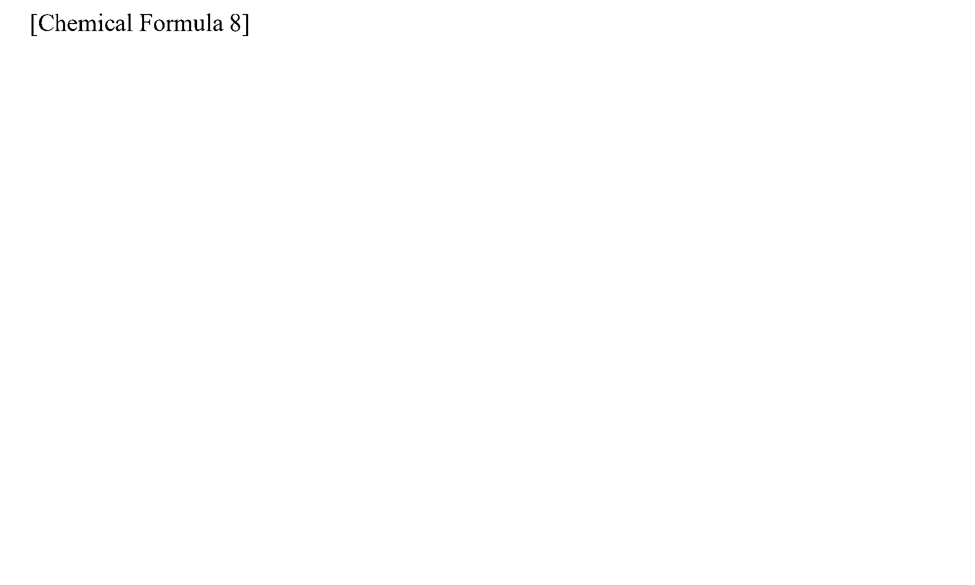

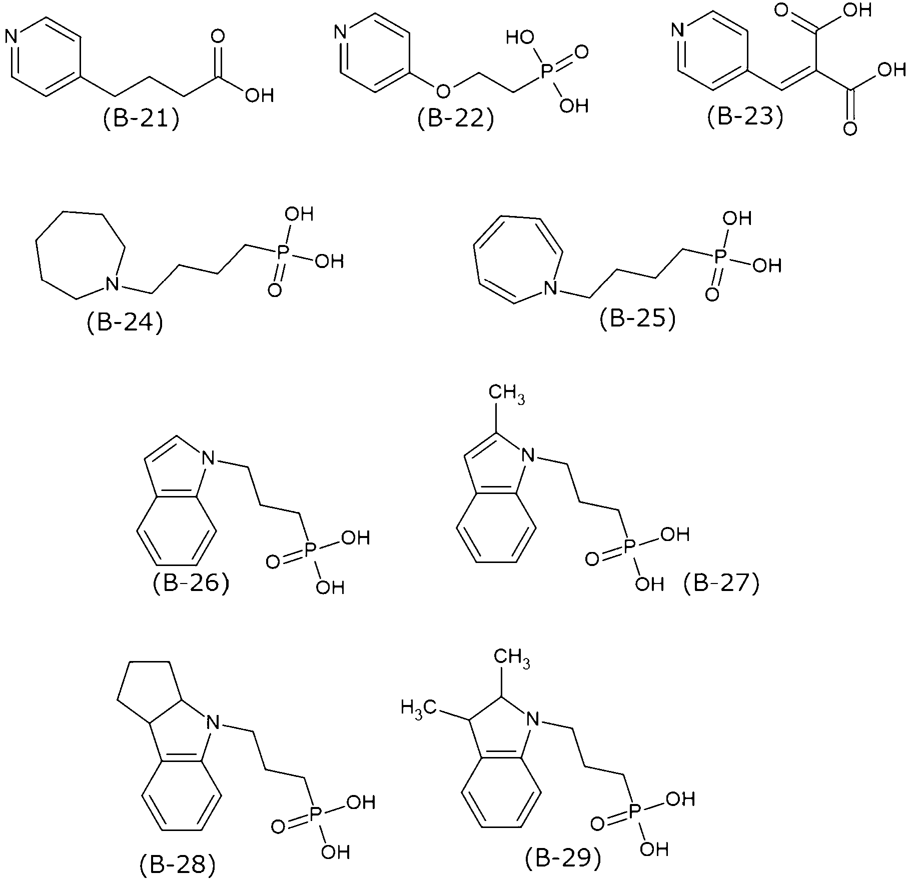

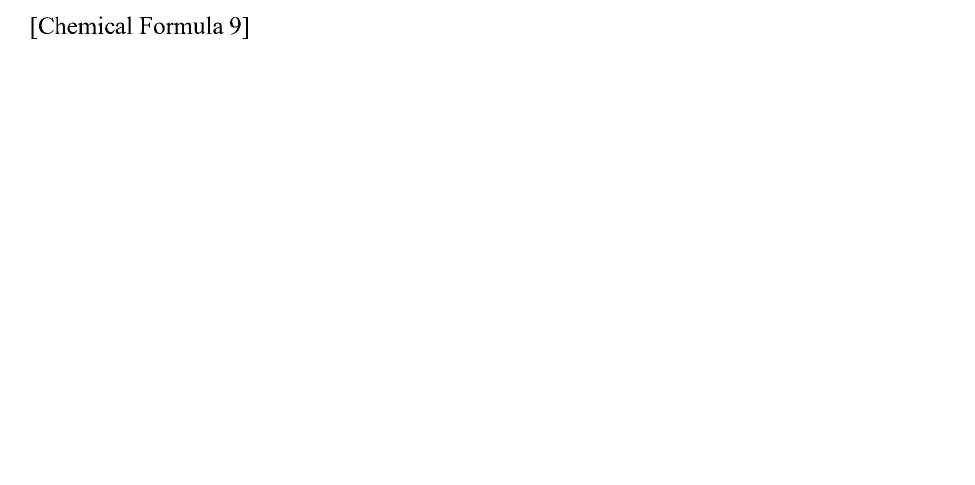

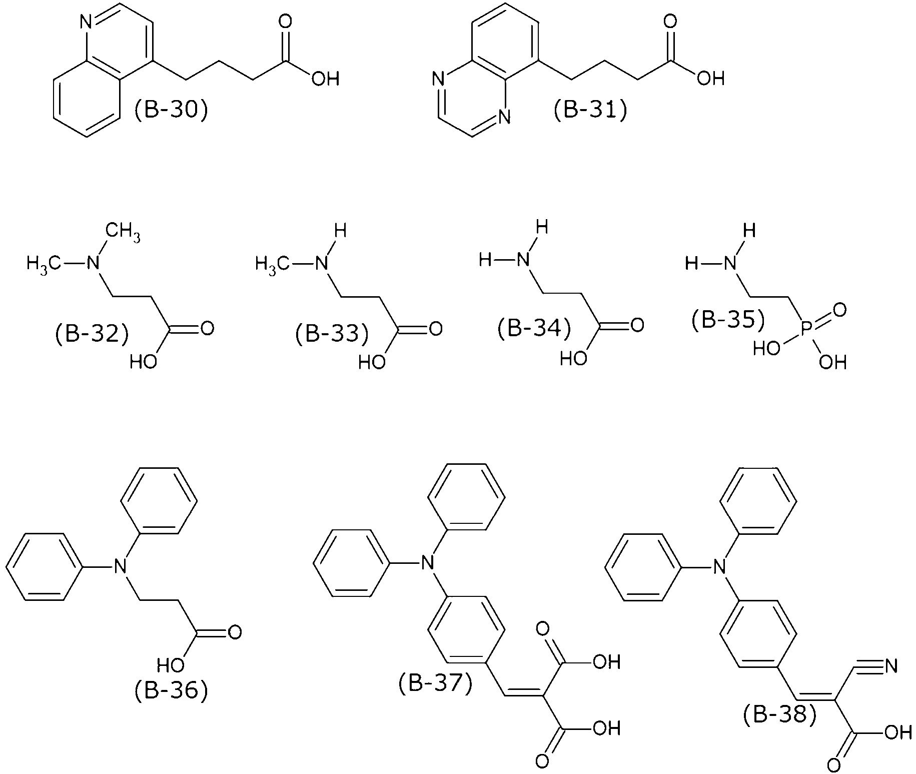

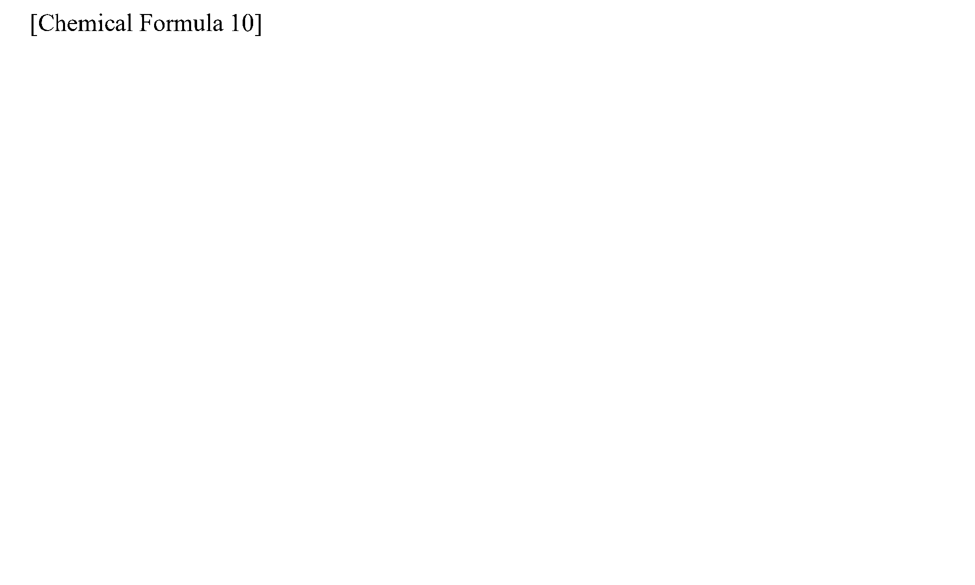

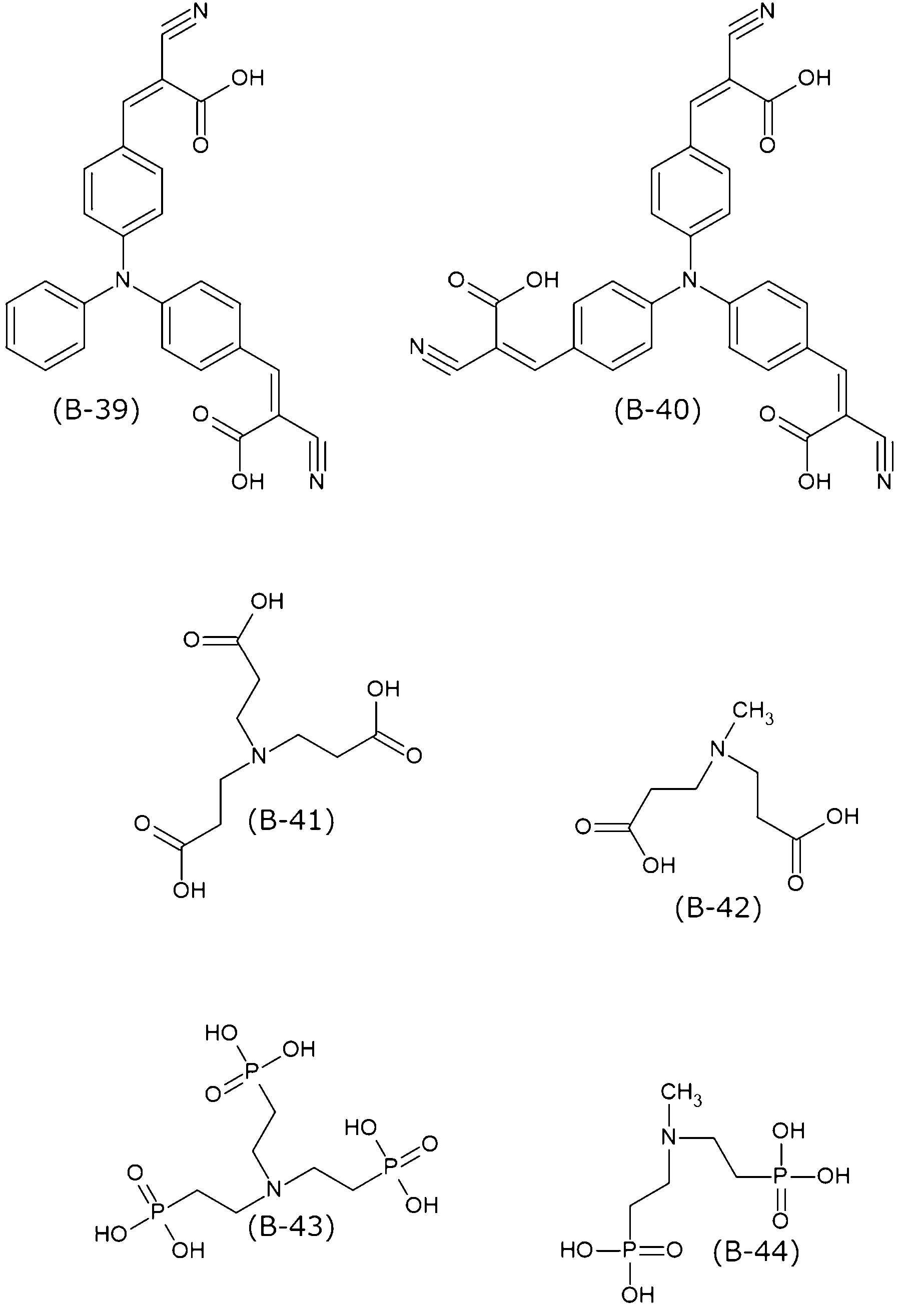

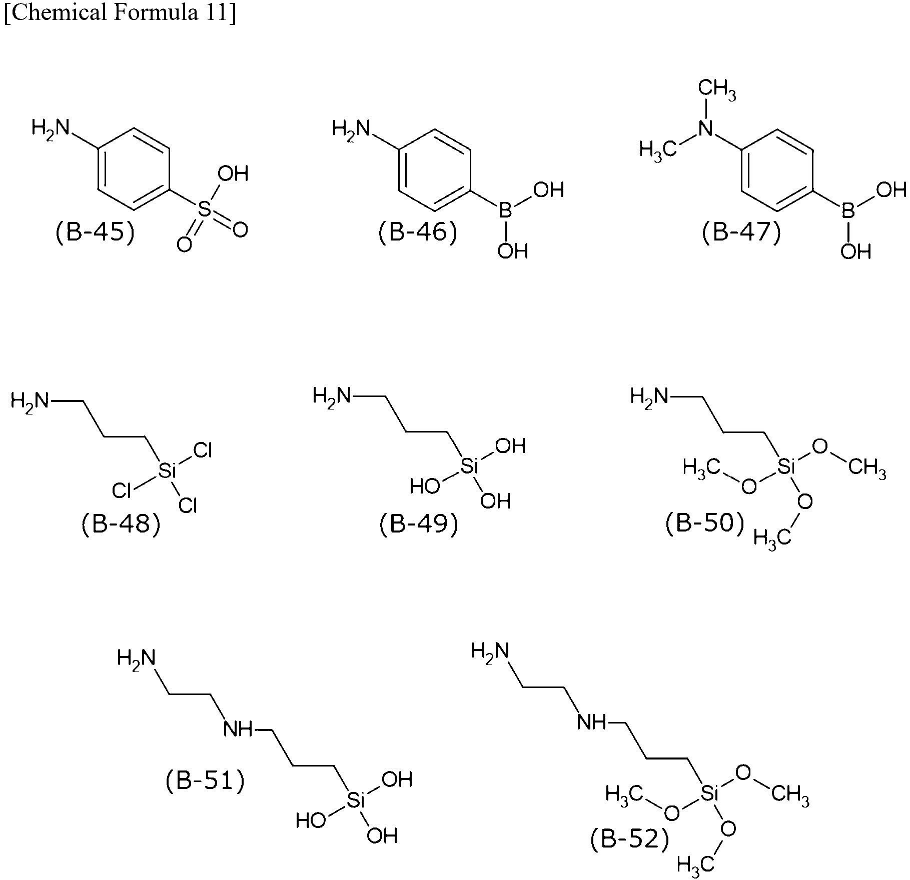

The compound represented by Chemical Formula (II) may be formed as, for example, a monomolecular layer on the p-type metal oxide semiconductor layer 13-1.

In the hole transport material layer 13-2, the total content of the compound (however, it includes the above-described salt form) represented by Chemical Formula (I) and the compound (however, it includes the above-described salt form) represented by Chemical Formula (II) is preferably 70 to 100 mass%, more preferably 90 to 100 mass%, and still more preferably 99 to 100 mass%, with respect to the mass of the hole transport material layer 13-2.

The molar ratio of the compound represented by Chemical Formula (II) (however, it includes the above-described salt form) to the compound represented by Chemical Formula (I) (however, it includes the above-described salt form) is preferably 1:100 to 1:1, more preferably 1:80 to 1:2, and still more preferably 1:50 to 1:5.

### (Method of Forming Hole Transport Material Layer)

A method of forming the hole transport material layer 13-2 is not particularly limited, but for example, the hole transport material layer 13-2 can be formed by causing a compound represented by Chemical Formula (I) or a compound represented by Chemical Formula (I) and Chemical Formula (II) to be adsorbed on the p-type metal oxide semiconductor layer 13-1 to form a monomolecular layer. The method of forming a monomolecular layer by causing the compound represented by Chemical Formula (I) or the compound represented by Chemical Formulas (I) and (II) to be adsorbed on the p-type metal oxide semiconductor layer 13-1 is not particularly limited, but for example, the compound represented by Chemical Formula (I) or the compound represented by Chemical Formulas (I) and (II) may be dissolved in a solvent and brought into contact with the p-type metal oxide semiconductor layer 13-1 for a bond therebetween. A bond between the compound represented by Chemical Formula (I) and the p-type metal oxide semiconductor layer 13-1 and a bond between the compound represented by Chemical Formula (II) and the p-type metal oxide semiconductor layer 13-1 are not particularly limited, and may be a physical bond or a chemical bond. The type of the bond is also not particularly limited, and may be, for example, any of a hydrogen bond, an ester bond, a chelate bond, and the like. The solvent for dissolving the compound represented by Chemical Formula (I) and the compound represented by Chemical Formula (II) is also not particularly limited, and may be, for example, one or both of water and an organic solvent. More specific examples of the solvent include water, alcohols such as methanol, ethanol, and 2-propanol, ethers such as diethyl ether and diisopropyl ether, ketones such as acetone and methyl isobutyl ketone, esters such as ethyl acetate, isobutyl acetate, and γ-butyrolactone, heterocycles such as tetrahydrofuran and thiophene, amides such as N, N-dimethylformamide, N, N-dimethylacetamide, and N-methylpyrrolidone, sulfoxides such as dimethylsulfoxide, sulfones such as diethylsulfone and sulfolane, nitriles such as acetonitrile and 3-methoxypropionitrile, aromatic compounds such as benzene, toluene, and chlorobenzene, halogen-based solvents such as dichloromethane and chloroform, fluorine-based solvents such as chlorofluorocarbon, hydrochlorofluorocarbon, and hydrofluorocarbon, and may be used alone or in combination of two or more kinds thereof.

A specific method of causing the compound represented by Chemical Formula (I) or the compounds represented by Chemical Formulas (I) and (II) to be adsorbed on the p-type metal oxide semiconductor layer 13-1 to form a monomolecular layer is not particularly limited, and examples of the method include known methods such as a dipping method, a spraying method, a spin coating method, and a bar coating method. The temperature at the time of adsorption is not particularly limited, but is preferably - 20°C to 100°C, and more preferably 0°C to 50°C. The adsorption time is also not particularly limited, but is preferably, for example, one second to 48 hours, and more preferably 10 seconds to one hour.

After the adsorption treatment, for example, cleaning may or may not be performed. The cleaning method is also not particularly limited, but for example, a known method may be appropriately used.

After the adsorption treatment or after the cleaning, the heat treatment may or may not be performed. The temperature of the heat treatment is preferably 50°C to 150°C, and more preferably 70°C to 120°C. The heat treatment time is preferably one second to 48 hours, and more preferably 10 seconds to one hour. The heat treatment may be performed, for example, in the atmosphere or in vacuum.

In the present embodiment, the "substituent" is not particularly limited, and examples thereof include an alkyl group, an alkenyl group, an alkynyl group, an unsaturated aliphatic hydrocarbon group, an alkoxy group, an aralkyl group, an aryl group, an arylalkenyl group, a heteroaryl group, a halogen atom (fluorine atom, chlorine atom, and/or bromine atom, and the like), a hydroxy group (-OH), a mercapto group (-SH), an alkylthio group (-SR, R represents an alkyl group), an amino group, a sulfo group, a nitro group, a diazo group, a cyano group, a nitrile group, and a trifluoromethyl group.

In addition, in the present embodiment, when an isomer such as a tautomer or a stereoisomer (examples: Geometric, Conformational and Optical Isomers) exists in the compound, any isomer can be used in the present embodiment unless otherwise specified. In the present embodiment, when the compound represented by Chemical formula (I) or Chemical formula (II) can form a salt, the salt can also be used in the present embodiment unless otherwise specified. The salt may be an acid addition salt or a base addition salt. Furthermore, the acid forming the acid addition salt may be an inorganic acid or an organic acid, and the base forming the base addition salt may be an inorganic base or an organic base. The inorganic acid is not particularly limited, and examples thereof include sulfuric acid, phosphoric acid, hydrofluoric acid, hydrochloric acid, hydrobromic acid, hydroiodic acid, hypofluorous acid, hypochlorous acid, hypobromous acid, hypoiodic acid, fluorous acid, chlorous acid, bromic acid, iodic acid, fluoric acid, chloric acid, bromic acid, iodic acid, perfluoric acid, perchloric acid, perbromic acid, and periodic acid. The organic acid is also not particularly limited, and examples thereof include p-toluenesulfonic acid, methanesulfonic acid, oxalic acid, p-bromobenzenesulfonic acid, carbonic acid, succinic acid, citric acid, benzoic acid, and acetic acid. The inorganic base is not particularly limited, and examples thereof include ammonium hydroxide, alkali metal hydroxide, alkaline earth metal hydroxide, carbonate, and hydrogen carbonate, and more specifically include sodium hydroxide, potassium hydroxide, potassium carbonate, sodium carbonate, sodium hydrogen carbonate, potassium hydrogen carbonate, calcium hydroxide, and calcium carbonate. The organic base is also not particularly limited, and examples thereof include ethanolamine, triethylamine, and tris (hydroxymethyl) aminomethane. The method of producing these salts is also not particularly limited, and for example, the salts can be produced by a method of appropriately adding the above-described acid or base to the compound by a known method, or the like.

### [Photoelectric Conversion Layer]

The photoelectric conversion layer 14 is not particularly limited, and may be, for example, the same as a photoelectric conversion layer used for a photoelectric conversion element such as a general solar cell. The photoelectric conversion layer 14 contains, for example, a perovskite compound. The perovskite compound may be, for example, an organic-inorganic perovskite compound represented by the following Chemical Formula (III).

XαYβZγ ... (III)

In Chemical Formula (III), the ratio of α:β:γ is 3:1:1, and β and γ represent integers larger than 1. X represents a halogen ion, Y represents an organic compound having an amino group, and Z represents a metal ion. The photoelectric conversion layer 14 containing a perovskite compound is preferably disposed adjacent to the electron transport layer 15 to be described later. It is noted that the ratio of α:β:γ is not necessarily 3:1:1 as in, for example, 3:1.05:0.95.

X in Chemical Formula (III) is not particularly limited, and can be appropriately selected according to a purpose, and examples thereof include halogen ions such as chlorine, bromine, and iodine. These may be used alone or in combination of two or more kinds thereof.

Examples of Y in Chemical Formula (III) include alkylamine compound ions (organic compounds having an amino group) such as methylamine, ethylamine, n-butylamine, and formamidine, and alkali metal ions such as cesium, potassium, and rubidium without being limited to organic ions. The alkylamine compound ion and the alkali metal ion may be used alone or in combination of two or more kinds thereof. Organic (alkylamine compound ion) and inorganic (alkali metal ion) can be used in combination, and for example, cesium ion and formamidine may be used in combination.

Z in Chemical Formula (III) is not particularly limited, and can be appropriately selected according to a purpose, and examples thereof include metals such as lead, indium, antimony, tin, copper, and bismuth. These may be used alone or in combination of two or more kinds thereof. In particular, lead is particularly preferably used in combination with tin. In addition, the perovskite layer preferably has a layered perovskite structure in which a layer made of a metal halide and a layer in which organic cation molecules are arranged are alternately laminated. The perovskite layer may contain an alkali metal. When the perovskite layer contains at least an alkali metal, it is advantageous in that the output is increased. Examples of the alkali metal include cesium, rubidium, and potassium. Among them, cesium is preferable.

As described above, the photoelectric conversion layer 14 may be a perovskite layer formed of a perovskite compound. The method of forming such a perovskite layer is not particularly limited, and can be appropriately selected according to the purpose, and examples thereof include a method in which a solution in which a metal halide and an alkylamine halide are dissolved or dispersed is applied and then dried.

Examples of the method of forming the perovskite layer include a two-step precipitation method in which a solution in which a metal halide is dissolved or dispersed is applied, dried, and then immersed in a solution in which an alkylamine halide is dissolved to form a perovskite compound.

Examples of the method of forming the perovskite layer include a method in which, while a solution in which a metal halide and an alkylamine halide are dissolved or dispersed is applied, a poor solvent (solvent having low solubility) for the perovskite compound is added to precipitate a crystal.

Examples of the method of forming the perovskite layer include a method in which a metal halide is vapor-deposited in a gas filled with methylamine or the like.

As a method of forming the perovskite layer, a method of precipitating a crystal by adding a poor solvent for the perovskite compound while applying a solution in which a metal halide and an alkylamine halide are dissolved or dispersed is particularly preferable. The method of applying these solutions is not particularly limited, and can be appropriately selected according to the purpose, and examples thereof include an immersion method, a spin coating method, a spraying method, a dipping method, a roller method, and an air knife method. In addition, as a method of applying the solution, for example, a method of precipitating the solution in a supercritical fluid using carbon dioxide or the like may be used. Examples of the poor solvent to be used include hydrocarbons such as n-hexane and n-octane, alcohols such as methanol, ethanol, and 2-propanol, ethers such as diethyl ether and diisopropyl ether, ketones such as acetone and methyl isobutyl ketone, esters such as ethyl acetate, isobutyl acetate, and γ-butyrolactone, nitriles such as acetonitrile and 3-methoxypropionitrile, aromatic hydrocarbon compounds such as benzene, toluene, and chlorobenzene, halogen-based solvents such as dichloromethane and chloroform, and fluorine-based solvents such as chlorofluorocarbon, hydrochlorofluorocarbon, and hydrofluorocarbon.

The thickness of the photoelectric conversion layer 14 (for example, a light absorbing layer, for example, a perovskite layer) is not particularly limited, but is preferably 50 to 1200 nm and more preferably 200 to 1000 nm from the viewpoint of further suppressing performance deterioration due to defects and peeling.

### [Electron Transport Layer]

The material used for the electron transport layer 15 is not particularly limited, and can be appropriately selected according to the purpose, but a semiconductor material is preferable. The semiconductor material is not particularly limited, and a known semiconductor material can be used, and examples thereof include a single semiconductor, a compound semiconductor, and an organic n-type semiconductor.

The single semiconductor is not particularly limited, and examples thereof include silicon and germanium.

The compound semiconductor is not particularly limited, and examples thereof include metal chalcogenides, specifically oxides such as titanium, tin, zinc, iron, tungsten, zirconium, hafnium, strontium, indium, cerium, yttrium, lanthanum, vanadium, niobium, and tantalum; sulfides such as cadmium, zinc, lead, silver, antimony, and bismuth; selenides such as cadmium and lead; and tellurides such as cadmium and the like. Examples of other compound semiconductors include phosphides such as zinc, gallium, indium, and cadmium, gallium arsenide, copper-indium-selenide, and copper-indium-sulfide.

The organic n-type semiconductor is not particularly limited, and examples thereof include a perylene tetracarboxylic anhydride, a perylene tetracarboxydiimide compound, a naphthalenediimide-bithiophene copolymer, a benzobisimidazobenzophenanthroline polymer, a fullerene compound such as C₆₀, C₇₀, or PCBM ([6,6]-phenyl-C₆₁-butyric acid methyl ester), a carbonyl bridge-bithiazole compound, ALq₃(tris (8-quinolinolato) aluminum), a triphenylenebipyridyl compound, a silole compound, and an oxadiazole compound.

Among the above-described materials used for the electron transport layer 15, an organic n-type semiconductor is particularly preferable.

The materials used for forming the electron transport layer 15 may be used alone or in combination of two or more kinds thereof. In addition, the crystal type of the semiconductor material is not particularly limited, and can be appropriately selected according to the purpose, and may be a single crystal, a polycrystal, or an amorphous.

The film thickness of the electron transport layer 15 is not particularly limited, and can be appropriately selected according to the purpose, but is preferably 5 nm to 1000 nm, and more preferably 10 nm to 700 nm.

The method of forming the electron transport layer 15 is not particularly limited, and can be appropriately selected according to the purpose. Examples thereof include a method of forming a thin film in vacuum (vacuum film formation method), a wet film formation method, and the like. Examples of the vacuum film formation method include a sputtering method, a pulsed laser deposition method (PLD method), an ion beam sputtering method, an ion assist method, an ion plating method, a vacuum deposition method, an atomic layer deposition method (ALD method), a chemical vapor deposition method (CVD method), and the like. Examples of the wet film formation method include a method of forming the film by applying a solvent in which an electron transport material is dissolved, and a sol-gel method in the case of an oxide semiconductor. The sol-gel method is a method in which a gel is produced from a solution through a chemical reaction such as hydrolysis or polymerization/condensation, and then densification is promoted by heat treatment. When the sol-gel method is used, the method of applying the sol solution is not particularly limited, and can be appropriately selected according to the purpose. Examples of the method include a dipping method, a spraying method, a wire bar method, a spin coating method, a roller coating method, a blade coating method, a gravure coating method, and a wet printing method including letterpress, offset, gravure, intaglio, rubber plate, and screen printing. The temperature in the heat treatment after applying the sol solution is preferably 80°C or higher, more preferably 100°C or higher.

After the electron transport layer 15 is formed, an electron injection layer (hole blocking layer) may be formed between the electron transport layer and the second electrode 16. Examples of the material used for the electron injection layer include BCP (bathocuproine), and cesium may be doped. The electron injection layer is preferably 1 to 100 nm, more preferably 3 to 20 nm.

A passivation layer may be formed between the photoelectric conversion layer 14 and the second electrode 16 (preferably between the photoelectric conversion layer 14 and the electron transport layer 15, more preferably between the photoelectric conversion layer 14 and the electron injection layer).

The passivation layer is also preferably formed in direct contact with the photoelectric conversion layer 14 and/or the electron injection layer.

The passivation layer may be composed only of an organic substance, may be composed only of an inorganic substance, or may be composed of both of them.

Examples of the organic substance include compounds represented by "R^{P1}NH₂", "R^{P1}CONH₂", "₂HN-R^{P2}-NH₂", "R^{P1}CONH-R^{P2}-NHCOR^{P1}", "R^{P1}NHCO-R^{P2}-CONHR^{P1}", and "R^{P1}CONH-R^{P2}-N-(R^{P1})₂" (these are collectively referred to as passivation layer organic substances). In the above, R^{P1} each independently represents a monovalent substituent (preferably, an organic group, preferably a hydrocarbon group, more preferably a hydrocarbon group having 1 to 10 carbon atoms), and R^{P2} each independently represents a divalent linking group (preferably, an organic group, preferably a hydrocarbon group, more preferably a hydrocarbon group having 1 to 10 carbon atoms). The molecular weight of the organic substance is preferably 40 to 600.

The organic substance may form a salt (acid addition salt or base addition salt) together with an acid or a base, and the organic substance may be one in which the organic substance for the passivation layer forms a salt together with an acid or a base. Examples of the acid forming the acid addition salt and the base forming the base addition salt include an acid or a base used when the compound represented by Chemical Formula (I) or Chemical Formula (II) forms a salt.

Specific examples of the organic substance are preferably ethylenediamine, 2-phenylethylamine, and acid addition salts thereof (hydroiodic acid salts and the like). The organic substances may be used alone or in combination of two or more kinds thereof.

Examples of the inorganic substance include metal oxides and metal oxynitrides, and examples thereof include silicon oxide, silicon nitride, aluminum oxide, silicon oxynitride, molybdenum oxide, and hafnium oxide. The inorganic substances may be used alone or in combination of two or more kinds thereof.

The passivation layer preferably contains the organic substance, and the content of the organic substance is preferably 30 to 100 mass%, more preferably 90 to 100 mass%, and still more preferably 98 to 100 mass%, with respect to the total mass of the passivation layer.

### [Second Electrode]

The second electrode 16 (which may be, for example, a back surface electrode) is, for example, a layer having a function of extracting electrons from the photoelectric conversion layer 14 via the electron transport layer. In addition, the second electrode 16 is, for example, a layer serving as an anode (negative electrode).

The second electrode 16 may be formed directly on the electron transport layer (also referred to as an electron injection layer) 15. The material of the second electrode 16 is not particularly limited, and for example, the same material as that of the first electrode 12 can be used. The shape, structure, and size of the second electrode 16 are not particularly limited, and can be appropriately selected according to the purpose. Examples of the material of the second electrode 16 include a metal, a carbon compound, a conductive metal oxide, and a conductive polymer.

Examples of the metal include platinum, gold, silver, copper, and aluminum.

Examples of the carbon compound include graphite, fullerene, carbon nanotube, and graphene.

Examples of the conductive metal oxide include ITO, FTO, and ATO.

Examples of the conductive polymer include polythiophene and polyaniline.

The materials used for formation of the second electrode 16 may be used alone or in combination of two or more kinds thereof.

The second electrode 16 can be formed by appropriately using a method such as coating, lamination, vacuum vapor deposition, CVD, or bonding on the electron transport layer 15 depending on the type of the material to be used and the type of the hole transport layer 13.

In the photoelectric conversion element 10 according to the present embodiment, at least one of the first electrode 12 and the second electrode 16 is preferably substantially transparent. When the photoelectric conversion element 10 of the present embodiment is used, it is preferable to make the electrode transparent and allow incident light to enter from the electrode side. In this case, a material that reflects light is preferably used for the back surface electrode (an electrode opposite to the transparent electrode, for example, the second electrode 16), and metal, glass on which a conductive oxide is deposited, plastic, a metal thin film, or the like is preferably used. It is also effective to provide an antireflection layer on the electrode on the incident light side.

It is noted that the configuration of the photoelectric conversion element 10 is not limited to the configuration of Fig. 1. For example, the support 11 may be disposed on the opposite side to Fig. 1 (the upper side of the second electrode 16 in Fig. 1), and the second electrode 16, the electron transport layer 15, the photoelectric conversion layer 14, the hole transport layer 13, and the first electrode 12 may be laminated in the above order on the support 11. In addition, for example, as described above, other components may or may not be present between the layers of the support 11, the first electrode 12, the hole transport layer 13, the photoelectric conversion layer 14, the electron transport layer 15, and the second electrode 16. In addition, an example in which the first electrode 12 is a transparent electrode and the second electrode 16 is a back surface electrode has been described, but the photoelectric conversion element 10 is not limited thereto. For example, in the photoelectric conversion element 10, conversely, the first electrode 12 may be a back surface electrode and the second electrode 16 may be a transparent electrode.

### [Sealing]

The photoelectric conversion element 10 (for example, a solar cell) of the present embodiment is preferably sealed to protect the device (the photoelectric conversion element 10 of the present embodiment) from water or oxygen. The structure of the sealing is not particularly limited, but may be, for example, the same as that of a general photoelectric conversion element (for example, a solar cell). Specifically, for example, the sealing material may be applied only to the outer peripheral portion of the photoelectric conversion element 10 of the present embodiment and may be covered with glass or a film, the sealing material may be applied to the entire surface of the photoelectric conversion element 10 of the present embodiment and may be covered with glass or a film, or the sealing material may be applied only to the entire surface of the photoelectric conversion element 10 of the present embodiment.

The material of a sealing member is not particularly limited, and can be appropriately selected according to the purpose. For example, it is preferable to cure the sealing member using an epoxy resin or an acrylic resin. However, the sealing member may not be cured, or only a part thereof may be cured.

The epoxy resin is not particularly limited, and examples thereof include an aqueous dispersion system, a solvent-free system, a solid system, a thermosetting type, a curing agent mixing type, and an ultraviolet curing type. Among these examples, the thermosetting type and the ultraviolet curing type are preferable, and the ultraviolet curing type is more preferable. It is noted that, even in the ultraviolet curing type, heating can be performed, and heating is preferably performed even after ultraviolet curing. Specific examples of the epoxy resin include a bisphenol A type, a bisphenol F type, a novolac type, a cyclic aliphatic type, a long chain aliphatic type, a glycidyl amine type, a glycidyl ether type, and a glycidyl ester type, and these may be used alone or in combination of two or more kinds thereof. In addition, it is preferable to mix a curing agent and various additives with the epoxy resin as necessary. An epoxy resin composition that is already commercially available can be used in the present embodiment. Among them, epoxy resin compositions developed and commercially available for solar cells and organic EL element applications are also available, and can be particularly effectively used in the present embodiment. Examples of the commercially available epoxy resin composition include TB3118, TB3114, TB3124, TB3125F (manufactured by ThreeBond Holdings Co., Ltd.), WorldRock5910, WorldRock5920, WorldRock8723 (manufactured by Kyoritsu Chemical Industry Co., Ltd.), WB90US (P), and WB90US-HV (manufactured by MORESCO Corporation).

The acrylic resin is not particularly limited, and for example, those developed and commercially available for solar cells and organic EL element applications can be effectively used. Examples of the commercially available acrylic resin composition include TB3035B and TB3035C (manufactured by ThreeBond Holdings Co., Ltd.).

The curing agent is not particularly limited, and can be appropriately selected according to a purpose, and examples thereof include an amine-based curing agent, an acid anhydride-based curing agent, a polyamide-based curing agent, and other curing agents. Examples of the amine curing agent include aliphatic polyamines such as diethylenetriamine and triethylenetetramine, and aromatic polyamines such as meta-phenylenediamine, diaminodiphenylmethane, and diaminodiphenylsulfone. Examples of the acid anhydride curing agent include phthalic anhydride, tetra and hexahydrophthalic anhydride, methyltetrahydrophthalic anhydride, methylnadic anhydride, pyromellitic anhydride, hetic anhydride, and dodecenyl succinic anhydride. Examples of other curing agents include imidazoles and polymercaptans. These may be used alone or in combination of two or more kinds thereof.

The additive is not particularly limited, and can be appropriately selected according to a purpose, and examples thereof include a filling material (filler), a gap agent, a polymerization initiator, a desiccant (moisture absorbent), a curing accelerator, a coupling agent, an organosilicate, a colorant, a flame retardant aid, an antioxidant, and an organic solvent. Among them, a filling material, a gap agent, a curing accelerator, a polymerization initiator, and a desiccant (moisture absorbent) are preferable, and a filling material and a polymerization initiator are more preferable. By containing a filling material as an additive, it is possible to suppress the infiltration of moisture and oxygen, and further to obtain effects such as reduction in volume shrinkage during curing, reduction in the amount of outgas during curing or heating, improvement in mechanical strength, and control of thermal conductivity and fluidity. Therefore, inclusion of a filling material as an additive is very effective in maintaining a stable output in various environments.

In addition, regarding the output characteristics of the photoelectric conversion element and the durability thereof, not only the influence of entering moisture and oxygen but also the influence of outgas generated at the time of curing or heating of a sealing member cannot be ignored. In particular, the influence of outgas generated at the time of heating greatly affects output characteristics in high temperature environment storage. When the sealing member contains a filling material, a gap agent, and a desiccant, the sealing member itself can suppress ingress of moisture and oxygen, and the amount of the sealing member used can be reduced, so that an effect of reducing outgas can be obtained. Inclusion of the filling material, the gap agent, and the desiccant in the sealing member is effective not only at the time of curing but also at the time of storing the photoelectric conversion element in a high-temperature environment.

The filling material is not particularly limited, and can be appropriately selected according to a purpose, and examples thereof include crystalline or amorphous silica, silicate minerals such as talc, and inorganic fillers such as alumina, aluminum nitride, silicon nitride, calcium silicate, and calcium carbonate. Among them, hydrotalcite is particularly preferable. Further, these may be used alone or in combination of two or more kinds thereof.

The average primary particle size of the filling material is not particularly limited, but is preferably 0.1 µm or more and 10 µm or less, and more preferably 1 µm or more and 5 µm or less. When the average primary particle size of the filling material is within the above preferable range, the effect of suppressing the entry of moisture and oxygen can be sufficiently obtained, a viscosity becomes appropriate, the adhesion to the substrate and the defoaming property are improved, and the control of the width of the sealing portion and the workability are also effective.

The content of the filling material is preferably 10 parts by mass or more and 90 parts by mass or less, and more preferably 20 parts by mass or more and 70 parts by mass or less, with respect to the entire sealing member (100 parts by mass). When the content of the filling is within the above preferred range, the effect of suppressing the infiltration of moisture and oxygen is sufficiently obtained, a viscosity is also appropriate, and the adhesion and workability are also improved.

The gap agent is also referred to as a gap control agent or a spacer agent. By including a gap material as an additive, it is possible to control a gap of the sealing portion. For example, when a sealing member is provided on the first substrate or the first electrode, and the second substrate is placed on the sealing member to perform sealing, a gap of the sealing portion is adjusted to the size of the gap agent by mixing the sealing member with the gap agent, so that the gap of the sealing portion can be easily controlled.

The gap agent is not particularly limited, but for example, a gap agent that is granular, has a uniform particle size, and has high solvent resistance and heat resistance is preferable, and can be appropriately selected according to the purpose. The gap agent preferably has high affinity with an epoxy resin and a spherical particle shape. Specifically, glass beads, silica fine particles, organic resin fine particles, and the like are preferable. These may be used alone or in combination of two or more kinds thereof. The particle size of the gap agent can be selected according to the gap of the sealing portion to be set, but is preferably 1 µm or more and 100 µm or less, and more preferably 5 µm or more and 50 µm or less.

The polymerization initiator is not particularly limited, but examples thereof include a polymerization initiator that initiates polymerization using heat or light, and can be appropriately selected according to the purpose, and examples thereof include a thermal polymerization initiator and a photopolymerization initiator. The thermal polymerization initiator is a compound that generates active species such as radicals and cations by heating, and examples thereof include azo compounds such as 2,2'-azobisbutyronitrile (AIBN) and peroxides such as benzoyl peroxide (BPO). As the thermal cationic polymerization initiator, a benzenesulfonic acid ester, an alkylsulfonium salt, or the like is used. As the photopolymerization initiator, a photocationic polymerization initiator is preferably used in the case of an epoxy resin. When the photocationic polymerization initiator is mixed with an epoxy resin and light irradiation is performed, the photocationic polymerization initiator is decomposed to generate an acid, the acid causes polymerization of the epoxy resin, and a curing reaction proceeds. The photocationic polymerization initiator has effects that volume shrinkage during curing is small, oxygen is not inhibited, and storage stability is high.

Examples of the photocationic polymerization initiator include an aromatic diazonium salt, an aromatic iodonium salt, an aromatic sulfonium salt, a methacerone compound, and a silanol-aluminum complex. As the polymerization initiator, a photoacid generator having a function of generating an acid by irradiation with light can also be used. The photoacid generator acts as an acid that initiates cationic polymerization, and examples thereof include ionic sulfonium salt-based and iodonium salt-based onium salts including a cationic part and an anionic part. These may be used alone or in combination of two or more kinds thereof.

The addition amount of the polymerization initiator is not particularly limited, and may vary depending on the material to be used, but is preferably 0.5 parts by mass or more and 10 parts by mass or less, and more preferably 1 part by mass or more and 5 parts by mass or less, with respect to the entire sealing member (100 parts by mass). When the addition amount is within the above preferable range, curing proceeds appropriately, remaining of an uncured product can be reduced, and excessive outgassing can be prevented.

The desiccant (also referred to as a moisture absorbent) is a material having a function of physically or chemically adsorbing and absorbing moisture, and moisture resistance can be further enhanced and the influence of outgas can be reduced by containing the desiccant in the sealing member. The desiccant is not particularly limited, and can be appropriately selected according to the purpose, but is preferably in the form of particles, and examples thereof include inorganic water-absorbent materials such as calcium oxide, barium oxide, magnesium oxide, magnesium sulfate, sodium sulfate, calcium chloride, silica gel, molecular sieve, and zeolite. Among them, zeolite having a large moisture absorption amount is preferable. These may be used alone or in combination of two or more kinds thereof.

The curing accelerator (also referred to as a curing catalyst) is a material that increases the curing speed, and is mainly used for a thermosetting epoxy resin. The curing accelerator is not particularly limited, and can be appropriately selected according to the purpose, and examples thereof include tertiary amines or tertiary amine salts such as DBU (1,8-diazabicyclo (5,4,0)-undecene-7) and DBN (1,5-diazabicyclo (4,3,0)-nonene-5), imidazole-based compounds such as 1-cyanoethyl-2-ethyl-4-methylimidazole and 2-ethyl-4-methylimidazole, and phosphines or phosphonium salts such as triphenylphosphine and tetraphenylphosphonium tetraphenylborate. These may be used alone or in combination of two or more kinds thereof.

The coupling agent is not particularly limited as long as it is a material having an effect of increasing molecular binding force, and can be appropriately selected according to the purpose, and examples thereof include a silane coupling agent. Specific examples thereof include silane coupling agents such as 3-glycidoxypropyltrimethoxysilane, 3-glycidoxypropylmethyldimethoxysilane, 3-glycidoxypropylmethyldimethoxysilane, 2-(3,4-epoxycyclohexyl) ethyltrimethoxysilane, N-phenyl-γ-aminopropyltrimethoxysilane, N-(2-aminoethyl) 3-aminopropylmethyldimethoxysilane, N-(2-aminoethyl) 3-aminopropylmethyltrimethoxysilane, 3-aminopropyltriethoxysilane, 3-mercaptopropyltrimethoxysilane, vinyltrimethoxysilane, N-(2-(vinylbenzylamino) ethyl) 3-aminopropyltrimethoxysilane hydrochloride, and 3-methacryloxypropyltrimethoxysilane. These may be used alone or in combination of two or more kinds thereof.

In the present embodiment, for example, a sheet-like adhesive can be used. The sheet-like adhesive is, for example, one in which a resin layer is formed in advance on a sheet with a sealing resin, and glass, a film having a high gas barrier property, or the like can be used for the sheet. Alternatively, the sheet-like adhesive may be formed of only the sealing resin. It is also possible to bond the sheet-like adhesive onto a sealing film. In this case, it is also possible to form a structure in which a hollow portion is provided in a sheet constituting the sheet-like adhesive applied onto the sealing film and then bond the sheet to a device.

When sealing is performed using a sealing film, the sealing film is disposed to face a support so as to sandwich a photoelectric conversion device. The shape, structure, size, and type of the base material of the sealing film are not particularly limited, and can be appropriately selected according to the purpose. The sealing film has a barrier layer that prevents passage of moisture and oxygen on the surface of a base material, and may be formed on only one surface or both surfaces of the base material.

The barrier layer may be made of a material mainly composed of, for example, a metal oxide, a metal, a mixture formed of a polymer and a metal alkoxide, or the like. Examples of the metal oxide include aluminum oxide, silicon oxide, and aluminum. Examples of the polymer include polyvinyl alcohol, polyvinyl pyrrolidone, and methyl cellulose. Examples of the metal alkoxide include tetraethoxysilane, triisopropoxyaluminum, 3-glycidoxypropyltrimethoxysilane, 3-mercaptopropyltrimethoxysilane, and 3-isocyanatopropyltriethoxysilane.

For example, the barrier layer may be transparent or opaque. In addition, the barrier layer may be a single layer by a combination of the above materials, or may have a plurality of laminated structures. As a method of forming the barrier layer, a known method can be used, and a coating method such as vacuum film formation such as a sputtering method, a dipping method, a roll coating method, a screen printing method, a spraying method, or a gravure printing method can be used.

### [Wiring]

In the photoelectric conversion element 10 (for example, a solar cell) of the present embodiment, a lead wire (wiring) is preferably connected to the first electrode 12 and the second electrode back surface electrode in order to efficiently take out a current generated by light. The lead wire is connected to the first electrode and the second electrode using, for example, a conductive material such as solder, silver paste, or graphite. The conductive material may be used alone or may be used in a mixed or laminated structure of two or more kinds thereof. From the viewpoint of physical protection, a portion to which the lead wire is attached may be covered with an acrylic resin or an epoxy resin.

The lead wire is a generic name of an electric wire for electrically connecting a power supply, an electronic component, and the like in an electric circuit, and examples thereof include a vinyl wire and an enameled wire.

The photoelectric conversion element 10 described above has excellent photoelectric conversion characteristics and an effect of improving durability.

### [Application]

The application and use method of the photoelectric conversion element 10 of the present embodiment are not particularly limited, and for example, the photoelectric conversion element can be widely used in the same application as a general photoelectric conversion element (for example, a general solar cell). The photoelectric conversion element (for example, a solar cell) of the present embodiment can be applied to a power supply device by being combined with, for example, a circuit board that controls a generated current. Examples of the devices using the power supply device include an electronic desktop calculator and a solar radio wristwatch. In addition, the solar cell of the present embodiment can also be applied as a power supply device to a mobile phone, an electronic paper, a thermohygrometer, and the like. In addition, the present invention can also be applied to an auxiliary power supply for extending a continuous use time of a rechargeable or dry-battery type electric appliance, and night use by combining with a secondary battery. In addition, it can also be used as a self-standing power supply that does not require battery replacement, power supply wiring, and the like.

### Examples

Hereinafter, examples of the present invention will be described. However, the present invention is not limited to the following examples.

### [Example 1]

A solar cell serving as a photoelectric conversion element was produced (manufactured) as follows.

Nickel acetate was dissolved in ethanol (50 mM/L), was heated and stirred at 60°C for 30 minutes, and was allowed to stand at room temperature for one hour. Monoethanolamine and nickel acetate were added thereto at a molar ratio of 1:1, and the mixture was heated and stirred at 60°C for 15 minutes. Further, ultrasonic treatment was performed at 40°C for 15 minutes, and the resulting mixture was allowed to stand at room temperature for 24 hours. 1 mL of this solution was placed on ITO of an ITO glass substrate (first electrode formed on glass substrate serving as support, 25 mm square size), a nickel oxide layer was formed on the ITO (first electrode) using a spin coater (4000 rpm, 30 seconds), and heat treatment was performed at 100°C for 10 minutes. The film thickness of this nickel oxide was 20 nm. On the nickel oxide layer, 1 mL of a DMF solution in which (A-06) (0.1 mmol/L) was dissolved was placed on nickel oxide of the ITO glass substrate (first electrode formed on glass substrate serving as support, 25 mm square size), and a monomolecular layer (hole transport layer) was formed on the ITO (first electrode) using a spin coater (3000 rpm, 30 seconds). Next, a solution obtained by dissolving cesium iodide (0.738 g), formamidine iodide (7.512 g), methylamine bromide (0.905 g), lead iodide (23.888 g), and lead bromide (1.022 g) in DMF (40.0 mL) and dimethyl sulfoxide (DMSO, 12.0 mL) was deposited on the substrate using spin coating. The spin coating was performed at 3000 rpm, and chlorobenzene (0.3 mL) was added dropwise after 30 seconds from the start. Thereafter, heating was performed at 150°C for 10 minutes to obtain a perovskite layer (photoelectric conversion layer). Then, 20 nm (electron transport layer) of C₆₀, bathocuproine (BCP, 8 nm) (electron injection layer), and Ag (100 nm) (second electrode) were deposited by vacuum deposition to prepare a photoelectric conversion element. After the preparation, the solar cell characteristics of the photoelectric conversion element of 25 mm square size were evaluated. The performance is shown in Table 1. In addition, as a light continuous irradiation test, a continuous irradiation test for 500 hours was performed using AM1.5G and Sun Test XLS+ adjusted to a light amount of 100 mW/cm². The retention rate of conversion efficiency measured before and after this test is also shown in Table 1.

The photoelectric conversion characteristics of the photoelectric conversion element prepared in Example 1 was measured by a method in accordance with the output measurement method of a silicon crystalline solar cell of JISC8913:1998. A solar simulator (SMO-250III type manufactured by Bunkoukeiki Co., Ltd.) combined with an air mass filter equivalent to AM 1.5 G was irradiated with light at a light amount of 100 mW/cm² using a secondary reference Si solar cell to obtain a light source for measurement, I-V curve characteristics were measured using a source meter (2400 type general-purpose source meter manufactured by Keithley Instruments Inc.) while a test sample of a perovskite-type solar cell (photoelectric conversion element prepared in Example 1) was irradiated with light, and a short circuit current (Isc), an open circuit voltage (Voc), a fill factor (FF), a short circuit current density (Jsc), and a photoelectric conversion efficiency (PCE) obtained from the I-V curve characteristics measurement were obtained. short-circuit current density (Jsc; mA/cm2) = Isc (mA)/effective light receiving surface S (cm2) photoelectric conversion efficiency (PCE; %) = Voc (V) × Jsc (mA/cm2) × FF × 100/100 (mW/cm2)

### [Example 2]

A photoelectric conversion element was produced (manufactured) in the same manner as in Example 1 except that a DMF solution in which (A-06) (0.1 mmol/L) and phosphonobutylic acid (12 mmol/L) were dissolved was used instead of the DMF solution in which (A-06) (0.1 mmol/L) was dissolved in Example 1, and the photoelectric conversion efficiency was measured. The solar cell characteristic results are shown in Table 1 below.

### [Example 3]

A photoelectric conversion element was produced (manufactured) in the same manner as in Example 1 except that a DMF solution in which (A-06) (0.1 mmol/L) and phosphonobutylic acid (6 mmol/L) were dissolved was used instead of the DMF solution in which (A-06) (0.1 mmol/L) was dissolved in Example 1, and the photoelectric conversion efficiency was measured. The solar cell characteristic results are shown in Table 1 below.

### [Example 4]

A photoelectric conversion element was produced (manufactured) in the same manner as in Example 1 except that a DMF solution in which (A-06) (0.1 mmol/L) and phosphonobutylic acid (0.1 mmol/L) were dissolved was used instead of the DMF solution in which (A-06) (0.1 mmol/L) was dissolved in Example 1, and the photoelectric conversion efficiency was measured. The solar cell characteristic results are shown in Table 1 below.

### [Example 5]

A photoelectric conversion element was produced (manufactured) in the same manner as in Example 1 except that a DMF solution in which (A-06) (0.1 mmol/L) and (B-35) (1.0 mmol/L) were dissolved was used instead of the DMF solution in which (A-06) (0.1 mmol/L) was dissolved in Example 1, and the photoelectric conversion efficiency was measured. The solar cell characteristic results are shown in Table 1 below.

### [Example 6]

A photoelectric conversion element was produced (manufactured) in the same manner as in Example 1 except that a DMF solution in which (A-16) (0.1 mmol/L) and terephthalic acid (2.0 mmol/L) were dissolved was used instead of the DMF solution in which (A-06) (0.1 mmol/L) was dissolved in Example 1, and the photoelectric conversion efficiency was measured. The solar cell characteristic results are shown in Table 1 below.

### [Example 7]

A photoelectric conversion element was produced (manufactured) in the same manner as in Example 1 except that a DMF solution in which (A-05) (0.1 mmol/L) and terephthalic acid (2.0 mmol/L) were dissolved was used instead of the DMF solution in which (A-06) (0.1 mmol/L) was dissolved in Example 1, and the photoelectric conversion efficiency was measured. The solar cell characteristic results are shown in Table 1 below.

### [Example 8]

A photoelectric conversion element was produced (manufactured) in the same manner as in Example 1 except that nickel copper oxide produced by the following production method was used instead of nickel oxide in Example 1, and a DMF solution in which (A-15) (0.1 mmol/L) was dissolved was used instead of the DMF solution in which (A-06) (0.1 mmol/L) was further dissolved, and the photoelectric conversion efficiency was measured. The solar cell characteristic results are shown in Table 1 below.
- Method of Producing Nickel Copper Oxide

Nickel acetate and acetylacetone copper (1:1 in molar ratio) were dissolved in 2-methoxyethanol (50 mM/L), were heated and stirred at 60°C for 30 minutes, and were allowed to stand at room temperature for one hour. Triethanolamine was added thereto in a molar ratio of 1:1 to the total of nickel acetate and acetylacetone copper, and the mixture was heated and stirred at 60°C for 15 minutes. Further, ultrasonic treatment was performed at 40°C for 15 minutes, and the resulting mixture was allowed to stand at room temperature for 24 hours. 1 mL of this solution was placed on ITO of an ITO glass substrate (first electrode formed on glass substrate serving as support, 75 mm square size), a nickel copper oxide layer was formed on the ITO (first electrode) using a spin coater (4000 rpm, 30 seconds), and heat treatment was performed at 100°C for 10 minutes. The film thickness of the nickel copper oxide was 18 nm.

### [Example 9]

A photoelectric conversion element was produced (manufactured) in the same manner as in Example 8 except that a DMF solution in which (A-15) (0.1 mmol/L) and phosphonobutylic acid (6.0 mmol/L) were dissolved was used instead of the DMF solution in which (A-06) (0.1 mmol/L) was dissolved in Example 8, and the photoelectric conversion efficiency was measured. The solar cell characteristic results are shown in Table 1 below.

### [Example 10]

A photoelectric conversion element was produced (manufactured) in the same manner as in Example 1 except that aluminum copper oxide produced by the following production method was used instead of nickel oxide in Example 1, and a DMF solution in which (A-15) (0.1 mmol/L) was dissolved was used instead of the DMF solution in which (A-06) (0.1 mmol/L) was dissolved, and the photoelectric conversion efficiency was measured. The solar cell characteristic results are shown in Table 1 below.
- Method of Producing Aluminum Copper Oxide

Aluminum acetylacetonate and acetylacetone copper (1:1 in molar ratio) were dissolved (50 mM/L) in 2-methoxyethanol, were heated and stirred at 60°C for 30 minutes, and were allowed to stand at room temperature for one hour. Triethanolamine was added thereto in a molar ratio of 1:1 to the total of aluminum acetylacetonate and acetylacetone copper, and the mixture was heated and stirred at 60°C for 15 minutes. Further, ultrasonic treatment was performed at 40°C for 15 minutes, and the resulting mixture was allowed to stand at room temperature for 24 hours. 1 mL of this solution was placed on ITO of an ITO glass substrate (first electrode formed on glass substrate serving as support, 25 mm square size), an aluminum copper oxide layer was formed on the ITO (first electrode) using a spin coater (4000 rpm, 30 seconds), and heat treatment was performed at 100°C for 10 minutes. The film thickness of this aluminum copper oxide was 15 nm.

### [Example 11]

A photoelectric conversion element was produced (manufactured) in the same manner as in Example 8 except that a DMF solution in which (A-15) (0.1 mmol/L) and phosphonobutylic acid (6.0 mmol/L) were dissolved was used instead of the DMF solution in which (A-06) (0.1 mmol/L) was dissolved in Example 10, and the photoelectric conversion efficiency was measured. The solar cell characteristic results are shown in Table 1 below.

### [Example 12]

A photoelectric conversion element was produced (manufactured) in the same manner as in Example 1 except that a DMF solution in which (A-06) (0.1 mmol/L) and glycine hydrochloride (12.0 mmol/L) were dissolved was used instead of the DMF solution in which (A-06) (0.1 mmol/L) was dissolved in Example 1, and the photoelectric conversion efficiency was measured. The solar cell characteristic results are shown in Table 1 below.

### [Example 13]

Instead of the DMF solution in which (A-06) (0.1 mmol/L) was dissolved in Example 1, a DMF solution in which (A-06) (0.1 mmol/L) and 2-aminoethylphosphonic acid (6.0 mmol/L) were dissolved was used to form a hole transport layer, then methanolic hydrochloric acid (0.5 mol/L) was placed on the hole transport layer, the hole transport layer was allowed to stand for one minute, and an extra solution was removed using a spin coater (3000 rpm, 30 seconds). A photoelectric conversion element was produced (manufactured) in the same manner as in Example 1 except for this operation, and the photoelectric conversion efficiency was measured. The solar cell characteristic results are shown in Table 1 below.

### [Comparative Example 1]

A photoelectric conversion element was produced (manufactured) in the same manner as in Example 1 except that the nickel oxide layer in Example 1 was not provided, and the photoelectric conversion efficiency was measured. The solar cell characteristic results are shown in Table 1 below.

### [Comparative Example 2]

A photoelectric conversion element was produced (manufactured) in the same manner as in Example 1 except that a tin oxide layer produced by the following production method was used instead of the nickel oxide layer in Example 1, and the photoelectric conversion efficiency was measured. The solar cell characteristic results are shown in Table 1 below.
· Method of Producing Tin Oxide Layer

A solution prepared by adding ion-exchanged water to a colloidal tin oxide solution (15%, water) to dilute the solution to 1.0% was used as an ultrasonic dispersion for 15 minutes. 1 mL of this solution was placed on ITO of an ITO glass substrate (first electrode formed on glass substrate serving as support, 25 mm square size), a tin oxide layer was formed on the ITO (first electrode) using a spin coater (4000 rpm, 30 seconds), and heat treatment was performed at 100°C for 10 minutes. The film thickness of this tin oxide layer was 17 nm.

### [Comparative Example 3]

A photoelectric conversion element was produced (manufactured) in the same manner as in Example 3 except that a DMF solution in which (A-06) (0.1 mmol/L) and phosphonobutylic acid (6.0 mmol/L) were dissolved was used instead of the DMF solution in which (A-06) (0.1 mmol/L) was dissolved in Comparative Example 2, and the photoelectric conversion efficiency was measured. The solar cell characteristic results are shown in Table 1 below.

### [Comparative Example 4]

A photoelectric conversion element was produced (manufactured) in the same manner as in Example 1 except that a PTAA layer produced by the following production method was used instead of the nickel oxide layer in Example 1, and the photoelectric conversion efficiency was measured. The solar cell characteristic results are shown in Table 1 below.
· Method of Producing PTAA Layer

1 mL of a chlorobenzene solution (10 ml) in which PTAA (0.05 g) was dissolved was placed on ITO of an ITO glass substrate (first electrode formed on glass substrate serving as support, 25 mm square size), a PTAA layer was formed on the ITO (first electrode) using a spin coater (4000 rpm, 30 seconds), and heat treatment was performed at 100°C for 10 minutes. The film thickness of the PTAA layer was 17 nm.

### [Comparative Example 5]

A photoelectric conversion element was produced (manufactured) in the same manner as in Example 1 except that a PEDOT layer produced by the following production method was used instead of the nickel oxide layer in Example 1, and a DMF solution in which (A-15) (0.1 mmol/L) was dissolved was used instead of the DMF solution in which (A-06) (0.1 mmol/L) was dissolved in Example 1, and the photoelectric conversion efficiency was measured. The solar cell characteristic results are shown in Table 1 below.
· Method of Producing PEDOT Layer
PEDOT: 1 mL of PSS (CLEVIOUS PVP AI 4083) was placed on ITO of an ITO glass substrate (first electrode formed on glass substrate serving as support, 25 mm square size), a PEDOT layer was formed on the ITO (first electrode) using a spin coater (5000 rpm, 30 seconds), and heat treatment was performed at 140°C for 30 minutes. The film thickness of this PEDOT was 24 nm.

**[Table 1]**

| | | | (For monomolecular layer formation) Hole transport material (Compound represented by Chemical Formula (I)) | Co-adsorbent (Compound represented by Chemical Formula (II)) | Solar cell characteristics (initial) | | | | After continuous light irradiation | Retention rate |
|---|---|---|---|---|---|---|---|---|---|---|
| | | | | | Voc(V) | Jsc(mA/cm²) | FF | PCE (%) | PCE (%) | (%) |
| Example 1 | p-type metal oxide semiconductor | NiO | A-06 | - | 1.17 | 23.2 | 79.9 | 21.69 | 20.90 | 96.4 |
| Example 2 | | NiO | A-06 | Phosphonobutylic acid | 1.19 | 23.1 | 80.1 | 22.02 | 20.80 | 94.5 |
| Example 3 | | NiO | A-06 | Phosphonobutylic acid | 1.18 | 22.9 | 80.1 | 21.64 | 20.60 | 95.2 |
| Example 4 | | NiO | A-06 | Phosphonobutylic acid | 1.17 | 23.2 | 79.9 | 21.69 | 20.80 | 95.9 |
| Example 5 | | NiO | A-06 | B-35 | 1.16 | 22.9 | 79.8 | 21.20 | 20.10 | 94.8 |
| Example 6 | | NiO | A-16 | Terephthalic acid | 1.17 | 22.7 | 79.5 | 21.11 | 19.80 | 93.8 |
| Example 7 | | NiO | A-05 | Terephthalic acid | 1.18 | 22.6 | 78.8 | 21.01 | 20.20 | 96.1 |
| Example 8 | | CuNiO | A-15 | - | 1.19 | 23.1 | 78.4 | 21.55 | 18.70 | 86.8 |
| Example 9 | | CuNiO | A-15 | Phosphonobutylic acid | 1.18 | 23.1 | 79.4 | 21.64 | 18.90 | 87.3 |
| Example 10 | | CuAlO | A-15 | - | 1.19 | 22.1 | 78.6 | 20.67 | 19.30 | 93.4 |
| Example 11 | | CuAlO | A-15 | Phosphonobutylic acid | 1.19 | 22.1 | 78.4 | 20.62 | 19.10 | 92.6 |
| Example 12 | | NiO | A-06 | Glycine hydrochloride | 1.18 | 22.9 | 80.2 | 21.67 | 20.70 | 95.5 |
| Example 13 | | NiO | A-06 | 2-aminoethylphosphonic acid | 1.17 | 22.7 | 80.2 | 21.30 | 20.50 | 96.2 |
| Comparative Example 1 | - | | A-06 | - | 1.07 | 22.8 | 78.8 | 19.22 | 14.80 | 77.0 |
| Comparative Example 2 | n-type metal oxide semiconductor | SnO₂ | A-06 | - | 0.60 | 0.52 | 19.3 | 0.06 | 0.01 | 16.6 |
| Comparative Example 3 | | SnO₂ | A-06 | Phosphonobutylic acid | 0.40 | 0.46 | 17.3 | 0.03 | 0.01 | 31.4 |
| Comparative Example 3 | p-type organic semiconductor | PTAA | A-06 | - | 0.78 | 19.3 | 43.1 | 6.49 | 3.40 | 52.4 |
| Comparative Example 4 | | PEDOT | A-15 | - | 0.68 | 17.6 | 45.7 | 5.47 | 2.80 | 51.2 |

From Table 1, it is apparent from comparison between Example 1 and Comparative Example 1 that by forming the p-type metal oxide semiconductor layer on the first electrode, it is possible to achieve both high output and high retention rate after the continuous light irradiation test. From comparison between Examples 1 and 2 and Comparative Examples 2 and 3, it is apparent that good performance can be achieved by using the p-type metal oxide semiconductor as in the present embodiment instead of the n-type metal oxide semiconductor such as tin oxide as the metal oxide formed on the first electrode. Further, from comparison between Example 1 and Comparative Example 4, and comparison between Example 8 and Comparative Example 5, it is apparent that good performance can be achieved by using the p-type metal oxide semiconductor of the present embodiment instead of the p-type organic semiconductor as the layer formed on the first electrode. From these results, it is apparent that the present invention exhibits excellent photoelectric conversion characteristics.

### <Synthesis Example 1>

### (Synthesis of Nickel Oxide Nanoparticles)

Nickel nitrate hexahydrate (4.51 mg, 15.5 mmol) and deionized water (15.5 mL) were placed in a flask, and were stirred at room temperature for 30 minutes. Then, an aqueous sodium hydroxide solution (10 M) was added dropwise at a rate of 0.5 mL/min while the mixture was stirred until the pH reached 10. After completion of the dropwise addition, stirring was continued for 30 minutes, a green crystal was separated with a centrifuge (10000 rpm, 10 minutes), a colorless and transparent supernatant was discarded, deionized water was then added, and centrifugation was further repeated two times. The separated nickel oxide was dried under vacuum at 80°C/10 hours to obtain a green powder. This powder was ground in a mortar and then heated at 270°C for two hours so as to obtain a black nickel oxide powder (1.14 mg, 98% yield).

### (Preparation of Nickel Oxide Dispersion Liquid)

The nickel oxide powder (1.00 mg) obtained above and deionized water (0.1 mL) were stirred at room temperature for one hour, and then ultrasonic waves were applied over five minutes to prepare a dispersion. The dispersion passed through a 0.45 µm PVDF filter, and the particle size was measured by a dynamic scattering method using a zeta potential/particle size/molecular weight measurement system ELSZ-2000 manufactured by Otsuka Electronics Co., Ltd. The results are shown in Fig. 2. From Fig. 2, it was found that the average particle size was 2.8 nm.

### [Examples 14]

A solar cell serving as a photoelectric conversion element was produced (manufactured) as follows.

100 µL of the nickel oxide dispersion liquid obtained above was placed on ITO of an ITO glass substrate (first electrode formed on glass substrate serving as support, 25 mm square size), a nickel oxide layer was formed on the ITO (first electrode) using a spin coater (3000 rpm, 25 seconds), and heat treatment was performed at 125°C for one hour. The film thickness of this nickel oxide was 14 nm. On the nickel oxide layer, 100 µL of a DMF solution in which (A-06) (0.1 mmol/L) was dissolved was placed on nickel oxide layer of the ITO glass substrate (first electrode formed on glass substrate serving as support, 25 mm square size), and a monomolecular layer (hole transport layer) was formed on the ITO (first electrode) using a spin coater (3000 rpm, 30 seconds). Next, a solution obtained by dissolving cesium iodide (0.738 g), formamidine iodide (7.512 g), methylamine bromide (0.905 g), lead iodide (23.888 g), and lead bromide (1.022 g) in DMF (40.0 mL) and dimethyl sulfoxide (DMSO, 12.0 mL) was deposited on the substrate using spin coating. The spin coating was performed at 3000 rpm, and chlorobenzene (0.3 mL) was added dropwise after 30 seconds from the start. Thereafter, heating was performed at 150°C for 10 minutes to obtain a perovskite layer (photoelectric conversion layer). Subsequently, a solution prepared by dissolving ethylenediamine hydrodiiodide (25.5 mg) in 2-propanol (25 mL) and chlorobenzene (25 mL) was deposited on the perovskite layer using spin coating (4000 rpm, 23 seconds). Thereafter, heating was performed at 100°C for five minutes so as to form a passivation layer on the perovskite layer. Then, 20 nm (electron transport layer) of C₆₀, bathocuproine (BCP, 8 nm) (electron injection layer), and Ag (100 nm) (second electrode) were deposited by vacuum deposition to prepare a photoelectric conversion element. After the preparation, the solar cell characteristics of the photoelectric conversion element of 25 mm square size were evaluated. The performance is shown in Table 2. In addition, as a light continuous irradiation test, a continuous irradiation test for 500 hours was performed using AM1.5G and Sun Test XLS+ adjusted to a light amount of 100 mW/cm². The retention rate of conversion efficiency measured before and after this test is also shown in Table 2.

The photoelectric conversion characteristics of the photoelectric conversion element prepared in Example 14 were measured by a method in accordance with the output measurement method of a silicon crystalline solar cell of JISC8913:1998. A solar simulator (SMO-250III type manufactured by Bunkoukeiki Co., Ltd.) combined with an air mass filter equivalent to AM 1.5 G was irradiated with light at a light amount of 100 mW/cm² using a secondary reference Si solar cell to obtain a light source for measurement, I-V curve characteristics were measured using a source meter (2400 type general-purpose source meter manufactured by Keithley Instruments Inc.) while a test sample of a perovskite-type solar cell (photoelectric conversion element prepared in Example 14) was irradiated with light, and a short circuit current (Isc), an open circuit voltage (Voc), a fill factor (FF), a short circuit current density (Jsc), and a photoelectric conversion efficiency (PCE) obtained from the I-V curve characteristics measurement were obtained. short-circuit current density (Jsc; mA/cm2) = Isc (mA)/effective light receiving surface S (cm2) photoelectric conversion efficiency (PCE; %) = Voc (V) × Jsc (mA/cm2) × FF × 100/100 (mW/cm2)

### [Example 15]

A photoelectric conversion element was produced (manufactured) in the same manner as in Example 14 except that the film formation by spin coating of ethylenediamine hydrodiiodide (EDAI₂) in Example 14 was changed to film formation by vacuum deposition (film thickness: 0.5 nm), and the photoelectric conversion efficiency was measured. The solar cell characteristic results are shown in Table 2 below.

### [Example 16]

A photoelectric conversion element was produced (manufactured) in the same manner as in Example 14 except that a solution in which EDAI₂ (25.5 mg) in Example 14 was dissolved in 2-propanol (25 mL) and chlorobenzene (25 mL) was changed to a solution in which phenylethylamine hydroiodic acid salt (PEAI) (20.1 mg) was dissolved in 2-propanol (25 mL), and the photoelectric conversion efficiency was measured. The solar cell characteristic results are shown in Table 2 below.

### [Example 17]

A photoelectric conversion element was produced (manufactured) in the same manner as in Example 14 except that the DMF solution in which (A-06) (0.1 mmol/L) was dissolved in Example 14 was changed to a DMF solution in which (A-06) (0.1 mmol/L) and 4-phosphonobutylic acid (0.3 mmol/L) were dissolved, and the photoelectric conversion efficiency was measured. The solar cell characteristic results are shown in Table 2 below.

### [Example 18]

A photoelectric conversion element was produced (manufactured) in the same manner as in Example 14 except that the DMF solution in which (A-06) (0.1 mmol/L) was dissolved in Example 14 was changed to a DMF solution in which (A-06) (0.1 mmol/L) and 4-phosphonobutylic acid (1.0 mmol/L) were dissolved, and the photoelectric conversion efficiency was measured. The solar cell characteristic results are shown in Table 2 below.

### [Example 19]

A photoelectric conversion element was manufactured (manufactured) in the same manner as in Example 1 except that a film formed using a solution in which EDAI₂ (25.5 mg) in Example 14 was dissolved in 2-propanol (25 mL) and chlorobenzene (25 mL) was not formed, and the photoelectric conversion efficiency was measured. The solar cell characteristic results are shown in Table 2 below.

### [Example 20]

A photoelectric conversion element was produced (manufactured) in the same manner as in Example 14 except that Ag (100 nm) (second electrode) in Example 14 was changed to Cu (100 nm), and the photoelectric conversion efficiency was measured. The solar cell characteristic results are shown in Table 2 below.

### [Example 21]

A photoelectric conversion element was produced (manufactured) in the same manner as in Example 14 except that the DMF solution in which (A-06) (0.1 mmol/L) was dissolved in Example 14 was changed to a DMF solution in which (A-15) (0.1 mmol/L) was dissolved, and the photoelectric conversion efficiency was measured. The solar cell characteristic results are shown in Table 2 below.

### [Example 22]

A photoelectric conversion element was produced (manufactured) in the same manner as in Example 14 except that the DMF solution in which (A-06) (0.1 mmol/L) was dissolved in Example 14 was changed to a DMF solution in which (A-15) (0.1 mmol/L) and phosphonobutylic acid (0.3 mmol/L) were dissolved, and the photoelectric conversion efficiency was measured. The solar cell characteristic results are shown in Table 2 below.

### [Example 23]

A photoelectric conversion element was prepared (manufactured) in the same manner as in Example 14 except that a black nickel oxide powder obtained by grinding the ground solid in the mortar in Synthesis Example 1 and then heating the ground solid at 270°C for two hours was changed to a black nickel oxide powder (average particle size: 1.6 nm) obtained by heating the ground solid at 200°C for eight hours, and the photoelectric conversion efficiency was measured. The solar cell characteristic results are shown in Table 2 below.

### [Example 24]

A photoelectric conversion element was prepared (manufactured) in the same manner as in Example 14 except that a black nickel oxide powder obtained by grinding the ground solid in the mortar in Synthesis Example 1 and then heating the ground solid at 270°C for two hours was changed to a black nickel oxide powder (average particle size: 4.1 nm) obtained by heating the ground solid at 240°C for eight hours, and the photoelectric conversion efficiency was measured. The solar cell characteristic results are shown in Table 2 below.

**[Table 2]**

| | p-type metal oxide | Monomolecular hole transport material | Co-adsorbent | Passivation material | Second electrode | Solar cell characteristics (initial) | | | | After continuous light irradiation | Retention rate (%) |
|---|---|---|---|---|---|---|---|---|---|---|---|
| | | | | | | Voc(V) | Jsc(mA/cm²) | FF | PCE (%) | PCE (%) | |
| Example 14 | NiO | A-06 | - | EDAI2 | Ag | 1.15 | 22.6 | 81.1 | 21.1 | 20.1 | 95.4 |
| Example 15 | NiO | A-06 | - | EDAI2 | Ag | 1.14 | 22.5 | 80.4 | 20.6 | 19.6 | 95.0 |
| Example 16 | NiO | A-06 | - | PEAI | Ag | 1.13 | 22.8 | 80.3 | 20.7 | 19.8 | 95.7 |
| Example 17 | NiO | A-06 | Phosphonobutylic acid | EDAI2 | Ag | 1.13 | 22.1 | 80.5 | 20.1 | 19.1 | 95.0 |
| Example 18 | NiO | A-06 | Phosphonobutylic acid | EDAI2 | Ag | 1.15 | 22.5 | 80.4 | 20.8 | 19.2 | 92.3 |
| Example 19 | NiO | A-06 | - | - | Ag | 1.14 | 22.2 | 80.5 | 20.4 | 18.9 | 92.8 |
| Example 20 | NiO | A-06 | - | EDAI2 | Cu | 1.17 | 22.4 | 81.3 | 21.3 | 20.3 | 95.3 |
| Example 21 | NiO | A-15 | - | EDAI2 | Ag | 1.14 | 22.8 | 79.8 | 20.7 | 18.8 | 90.6 |
| Example 22 | NiO | A-15 | Phosphonobutylic acid | EDAI2 | Ag | 1.13 | 21.9 | 80.1 | 19.8 | 18.3 | 92.3 |
| Example 23 | NiO | A-06 | - | EDAI2 | Ag | 1.12 | 21.8 | 80.4 | 19.6 | 18.3 | 93.2 |
| Example 24 | NiO | A-06 | - | EDAI2 | Ag | 1.13 | 22.3 | 80.2 | 20.2 | 18.5 | 91.5 |

As described above, it was confirmed from the present Examples that good solar cell characteristics and good durability can be obtained by using the hole transport material of the above-described aspect for the hole transport layer.

The present invention has been described above with reference to the embodiments and examples. However, the present invention is not limited to the embodiments and examples described above, and can be arbitrarily and appropriately combined, changed, or selected and adopted as necessary without departing from the gist of the present invention.

### Industrial Applicability

As described above, the photoelectric conversion element of the present invention is useful as, for example, a solar cell. The application and use method of the photoelectric conversion element of the present invention are not particularly limited, and for example, the photoelectric conversion element can be applied to a wide range of fields in the same application and use method as those of a general photoelectric conversion element (for example, a general solar cell).

### Reference Signs List

- 10: PHOTOELECTRIC CONVERSION ELEMENT
- 11: SUPPORT
- 12: FIRST ELECTRODE
- 13: HOLE TRANSPORT LAYER
- 13-1: p-TYPE METAL OXIDE SEMICONDUCTOR LAYER
- 13-2: HOLE TRANSPORT MATERIAL LAYER
- 14: PHOTOELECTRIC CONVERSION LAYER
- 15: ELECTRON TRANSPORT LAYER
- 16: SECOND ELECTRODE

## Claims

1. A photoelectric conversion element comprising a first electrode, a hole transport layer, a photoelectric conversion layer, an electron transport layer, and a second electrode laminated in this order, wherein
the photoelectric conversion layer contains a perovskite compound, and
the hole transport layer includes a p-type metal oxide semiconductor layer laminated on a main surface of the first electrode, the main surface being located on a side of the photoelectric conversion layer, and a hole transport material layer laminated on a main surface of the p-type metal oxide semiconductor layer, the main surface being located on the side of the photoelectric conversion layer, the hole transport material layer containing a compound represented by the following Chemical Formula (I)
Ar¹-(L¹-X¹)n ... (I),
wherein, in Chemical Formula (I), Ar¹ is a structure including an aromatic ring, atoms constituting the aromatic ring may contain a heteroatom, and Ar¹ may have a substituent other than -L¹-X¹, n is an integer of 1 or more, and when n is 2 or more, structures represented by -L¹-X¹ may be the same as or different from each other, L¹ is a divalent linking group bonding Ar¹ to X¹ or a single bond, and X¹ is a group capable of forming a chemical bond or a hydrogen bond with p-type metal oxide semiconductor.

2. The photoelectric conversion element according to claim 1, wherein the hole transport material layer contains a compound represented by the following Chemical Formula (II)
A¹-L²-X² ... (II),
wherein, A¹ is an atomic group including one or more substituents or structures selected from the group consisting of an alkoxy group, a hydroxy group, a carboxy group, a dihydroxyphosphoryl group, a dialkylphosphoryl group, a hydroxysulfonyl group, an amino group, a monoalkylamino group, a dialkylamino group, a monoarylamino group, a diarylamino group, a monoalkylaminocarbonyl group, a dialkylaminocarbonyl group, an alkylcarbonyloxy group, an alkoxycarbonyl group, an aminocarbonyl group, an aminocarbonylamino group, an alkylcarbonylamino group, an alkylsulfonylamino group, an aminosulfonyl group, and a nitrogen-containing heterocyclic group, L² is a divalent linking group bonding A¹ to X² or a single bond, and X² is a group capable of forming a chemical bond or a hydrogen bond with the first electrode.

3. The photoelectric conversion element according to claim 1 or 2, wherein the compound represented by Chemical Formula (I) forms a monomolecular layer.

4. The photoelectric conversion element according to claim 2, wherein a molar ratio of the compound represented by Chemical Formula (II) to the compound represented by Chemical Formula (I) is 1:100 to 1: 1.

5. The photoelectric conversion element according to claim 1 or 2, wherein X¹ in Chemical Formula (I) is selected from the group consisting of a dihydroxyphosphoryl group (-P = O(OH)₂), a carboxy group (-COOH), a sulfo group (-SO₃H), a boronic acid group (-B(OH)₂), a trihalogenated silyl group (-SiX₃, where X is a halo group), a trialkoxysilyl group (-Si(OR)₃, where R is an alkyl group), a trihydroxysilyl group, and a dialkylphosphoryl group.

6. The photoelectric conversion element according to claim 2, wherein X¹ in Chemical Formula (II) is selected from the group consisting of a dihydroxyphosphoryl group (-P = O(OH)₂), a carboxy group (-COOH), a sulfo group (-SO₃H), a boronic acid group (-B(OH)₂), a trihalogenated silyl group (-SiX₃, where X is a halo group), a trialkoxysilyl group (-Si(OR)₃, where R is an alkyl group), a trihydroxysilyl group, and a dialkylphosphoryl group.

7. The photoelectric conversion element according to claim 1 or 2, wherein the perovskite compound is an organic-inorganic perovskite compound.

8. The photoelectric conversion element according to claim 1 or 2, wherein the perovskite compound contains at least one of tin and lead.

9. The photoelectric conversion element according to claim 7, wherein the organic-inorganic perovskite compound contains at least one of tin and lead.

10. The photoelectric conversion element according to claim 1, wherein at least a part of the compound represented by Chemical Formula (I) forms an acid addition salt.

11. The photoelectric conversion element according to claim 2, wherein at least a part of the compound represented by Chemical Formula (II) forms an acid addition salt.

12. The photoelectric conversion element according to claim 1, wherein the p-type metal oxide semiconductor layer is formed of particles of the p-type metal oxide semiconductor.

13. The photoelectric conversion element according to claim 12, wherein each of the particles of the p-type metal oxide semiconductor has a diameter of 1.0 to 30.0 nm.
